(19) **Europäisches Patentamt / European Patent Office / Office européen des brevets**

(11) **EP 4 289 008 B1**

(12) **FASCICULE DE BREVET EUROPEEN**

(45) Date de publication et mention
de la délivrance du brevet:
**26.03.2025 Bulletin 2025/13**

(21) Numéro de dépôt: **22706740.2**

(22) Date de dépôt: **01.02.2022**

(51) Classification Internationale des Brevets (IPC):
$H01L\ 31/0304^{(2006.01)}$ $H01L\ 31/0352^{(2006.01)}$
$H01L\ 31/036^{(2006.01)}$ $H01L\ 31/103^{(2006.01)}$
$H01L\ 31/105^{(2006.01)}$

(52) Classification Coopérative des Brevets (CPC):
**H10F 77/1248; H10F 30/2215; H10F 30/222;
H10F 30/223; H10F 39/184; H10F 77/146;
H10F 77/16**

(86) Numéro de dépôt international:
**PCT/EP2022/052347**

(87) Numéro de publication internationale:
**WO 2022/167419 (11.08.2022 Gazette 2022/32)**

(54) **DETECTEUR INFRAROUGE AMELIORE VIA L'INGENIERIE DE LA MASSE EFFECTIVE DES PORTEURS DE CHARGES**

DURCH ENGINEERING DER EFFEKTIVEN LADUNGSTRÄGERMASSE VERBESSERTER INFRAROTDETEKTOR

INFRARED DETECTOR IMPROVED VIA ENGINEERING OF THE EFFECTIVE MASS OF CHARGE CARRIERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.02.2021 FR 2101135**

(43) Date de publication de la demande:
**13.12.2023 Bulletin 2023/50**

(73) Titulaires:
- **LYNRED**
  **91120 Palaiseau (FR)**
- **Commissariat à l'Energie Atomique et aux Energies Alternatives**
  **75015 Paris (FR)**

(72) Inventeurs:
- **EVIRGEN, Axel**
  **91767 Palaiseau (FR)**
- **REVERCHON, Jean-Luc**
  **91767 Palaiseau (FR)**
- **TRINITE, Virgnie**
  **91767 Palaiseau (FR)**

(74) Mandataire: **Atout PI Laplace
Immeuble Up On
25 Boulevard Romain Rolland
CS 40072
75685 Paris Cedex 14 (FR)**

(56) Documents cités:
**JP-A- H06 151 940    JP-A- H08 160 472
US-A- 5 136 602**

## Description

### Champ d'application

La présente invention concerne le domaine de l'imagerie pour l'infra-rouge (IR) et en particulier un détecteur de rayonnement ou photo détecteur fabriqué avec des hétérostructures à base de matériaux semi-conducteurs de type III-V. Plus particulièrement, l'invention concerne un dispositif d'imagerie dans l'infrarouge à ondes courtes (SWIR) et l'infrarouge à ondes moyennes (MWIR) à des températures non cryogéniques.

### Problème soulevé

Les imageurs opérant dans la gamme infrarouge sont généralement constitués par assemblage d'une matrice comprenant une pluralité de pixels élémentaires à base de photodiodes transformant un flux de photons incidents en porteurs de charges photo générés, et d'un circuit de lecture couramment dénommé ROIC pour « Read Out Integrated Circuit » en anglais pour traiter le signal électrique issu des pixels du détecteur.

L'invention se propose de résoudre un problème technique dans ce domaine consistant à concevoir un détecteur matriciel fonctionnant dans l'infrarouge à ondes courtes (SWIR) et l'infrarouge à ondes moyennes (MWIR) à des températures non cryogéniques en améliorant le rendement quantique du détecteur tout en minimisant en même temps le phénomène de diaphonie (traduction du terme cross-talk en Anglais) entre les pixels de la matrice et en minimisant en outre le bruit de courant noir par rapport aux solutions de l'état de l'art.

Nous allons commencer par expliquer physiquement ces trois caractéristiques interdépendantes d'un capteur matriciel infrarouge.

A titre d'illustration, dans un espace (X,Y,Z) on définit l'axe Δ de chaque pixel selon la direction Z, et le plan ayant pour normale l'axe du pixel, dit plan normal, est le plan (X, Y).

Chaque détecteur matriciel infrarouge est caractérisé par une longueur d'onde de coupure λc définie par le gap d'énergie effective $Eg_{eff}$ de la zone absorbante de chaque pixel du détecteur matriciel selon la relation Planck-Einstein λc=hc/$Eg_{eff}$ avec h la constante de Planck et c la célérité de la lumière dans le vide. La longueur de coupure dépend alors de la structure de bandes d'énergie des matériaux utilisés pour la réalisation de la zone absorbante du pixel.

On entend par « rendement quantique » d'un détecteur de rayonnement IR à base de semi-conducteur le rapport du nombre de paires électrons/trous générés par effet photoélectrique au nombre de photons traversant la structure d'un pixel appartenant au détecteur de rayonnement IR. Le rendement quantique dépend du coefficient d'absorption et de la longueur de diffusion $L_{dz}$ dans la structure du pixel selon l'axe du pixel. Le coefficient d'absorption dépend des matériaux utilisés pour la réalisation de la structure du pixel. La longueur de diffusion $L_{dz}$ selon l'axe du pixel augmente avec le coefficient de diffusion selon l'axe du pixel. Le coefficient de diffusion est inversement proportionnel à la masse effective $m_{hz}$ des porteurs de charges minoritaires (trous dans le cas d'une zone absorbante dopée N) selon l'axe du pixel.

Le phénomène de diaphonie (cross-talk) provient de l'interférence entre des pixels adjacents, les charges photo générées par un pixel pouvant diffuser vers un pixel voisin selon le plan ayant pour normale l'axe du pixel. L'amplitude du phénomène de diaphonie dans un détecteur matriciel infrarouge augmente avec la longueur de diffusion des porteurs de charges minoritaires dans le plan normal (X,Y) notée $L_{dx,y}$. La longueur de diffusion $L_{dx,y}$ selon le plan normal au pixel augmente avec le coefficient de diffusion dans le même plan. Le coefficient de diffusion est inversement proportionnel aux masses effectives $m_{hx}$ et $m_{hy}$ des porteurs de charges minoritaires (trous dans le cas d'une zone absorbante dopée N) dans le plan normal au pixel.

Le courant d'obscurité $J_{noir}$ est le courant de porteurs de charges générés en l'absence de rayonnements incidents dans les matériaux qui composent la zone absorbante d'un pixel de la matrice de détection. On peut exprimer le courant noir par la formule suivante :

$$ J_{noir} = \frac{n_i{}^2}{\tau N} d $$

Avec $n_i$ la densité de porteurs de charge intrinsèque dans la zone d'absorption, $\tau$ la durée de vie des porteurs de charge minoritaires, N est le dopage et d est l'épaisseur de la zone absorbante. N et d sont des paramètres dimensionnels, $\tau$ dépend des conditions de fabrication. Ces trois paramètres sont à optimiser pour trouver un compromis permettant de minimiser le courant d'obscurité tout en gardant un rendement quantique suffisant pour un bon fonctionnement. $n_i$ est plus fondamental et dépend de la masse effective des porteurs de charge minoritaires selon l'axe du pixel $m_{hz}$ et selon les plan normal au pixel $m_{hx}$ $m_{hy}$. L'ingénierie de la composition des matériaux de la zone d'absorption permet de contrôler lesdites masses effectives afin de trouver le compromis entre le rendement quantique, le courant d'obscurité et la diaphonie et cela pour une fréquence de coupure donnée à une température de fonctionnement donnée.

Pour résumer, nous avons démontré que : d'une part, le rendement quantique est une caractéristique technique qui détermine les performances électro-optiques d'un détecteur infra-rouge. D'autre part, le bruit de courant noir et le phénomène de diaphonie présentent des contraintes techniques qui limitent ladite performance.

Le problème technique à résoudre est alors de développer des détecteurs infrarouges en SWIR (1.4 µm

à 3 $\mu$m) et MWIR (3 $\mu$m à 8 $\mu$m) avec des pixels comprenant des zones absorbantes permettant avec une amélioration des critères interdépendants suivants : maximisation du rendement quantique et minimisation des contraintes de diaphonie et de bruit de courant noir à une fréquence de coupure donnée.

## Art antérieur/ Restrictions de l'état de l'art

La demande de brevet européen EP3482421B1 décrit un détecteur d'image infra-rouge matriciel comprenant une pluralité pixels. La structure planaire d'absorption de chaque pixel selon la solution proposée dans cette demande est réalisée par un matériau massif InGaAsSb sur un substrat en matériau GaSb dans une architecture verticale spécifique. De plus, le brevet européen EP1642345B1 décrit un détecteur de rayonnement infra-rouge matriciel comprenant une pluralité de pixels. La structure planaire d'absorption de chaque pixel selon la solution proposée par ce brevet est réalisée par un matériau massif InGaAsSb sur un substrat en matériau GaSb.

L'inconvénient des solutions proposées par ces deux documents est que le phénomène de diaphonie s'amplifie lorsque le pas du pixel atteint une distance inférieure à 15$\mu$m. De plus, les solutions proposées par ces deux documents sont incapables de fonctionner à des fréquences de coupure autour de 5$\mu$m.

La publication « Strain-induced enhancement of near-infrared absorption in Ge epitaxial layers grown on Si substrate" de "Ikishawa et al" présente un détecteur infrarouge avec une zone d'absorption en Germanium massif déposé par épitaxie sur Silicium. L'inconvénient de cette solution est que la fabrication du détecteur présente un traitement thermique des couches épitaxiées. Le traitement thermique et l'amplitude du désaccord de mailles entre le silicium et le germanium engendrent des dislocations générées par la relaxation du matériau composant la zone absorbante. Ainsi, le détecteur infrarouge présentera une fragilité d'un point de vue mécanique et une dégradation des performances électro-optiques des pixels

La publication « Infrared absorption enhancement in light and heavyhole inverted Ga1xlnxAs/Al1ylnyAs quantum wells » de « Xie et al » présente un détecteur infrarouge à puits quantiques InGaAS/InAlAs en contraintes compensées. L'inconvénient de la solution proposée par ce document est qu'elle n'est pas fonctionnelle dans l'infrarouge à ondes courtes (SWIR de 1.4$\mu$m à 3 $\mu$m) et dans l'infrarouge à ondes moyennes (MWIR de 3$\mu$m à 8$\mu$m).

Le document JPH06151940A décrit un détecteur de rayonnements infrarouges formant un pixel et comprenant une structure planaire absorbante en InGaAS de type N réalisée par épitaxie sur un substrat en InP.

## Réponse au problème et apport solution

Pour pallier les limitations des solutions existantes en ce qui concerne l'optimisation du point de compromis entre le rendement quantique, la minimisation de la diaphonie et du courant d'obscurité dans le SWIR et le MWIR, l'invention propose plusieurs modes de réalisation d'une structure de pixel comprenant une structure planaire d'absorption présentant une bande de valence avec niveau d'énergie maximal occupé par les trous légers supérieurs à celui occupé par les trous lourds selon l'axe du pixel. La structure planaire d'absorption selon l'invention peut être réalisée par un super-réseau ou en un matériau massif. L'invention détaille des modes de réalisation avec des exemples de choix de matériaux pour la structure planaire d'absorption, des plages de compositions des alliages semiconducteurs et des plages de dimensionnement des épaisseurs des couches de la structure planaire d'absorption selon l'invention. Les compositions (fractions molaires des alliages III-V) des matériaux utilisés pour réaliser la ou les couches de la structure planaire d'absorption selon l'invention sont choisies de façon à inverser les trous lourds et les trous légers selon l'axe du pixel tout en évitant l'appartition de dislocations d'interface due à la relaxation des matériaux. Cela permet d'améliorer en même temps, par rapport aux solutions de l'état de l'art, les performances du detecteur IR en terme de rendement quantique, de réduction du courant d'obscurité et de réduction de la diaphonie (cross-talk).

## Résumé /Revendications

L'invention a pour objet un dispositif de détection de rayonnements infrarouges comprenant au moins un pixel ayant un axe selon une direction Z, ledit pixel comprenant une première structure planaire absorbante comprenant au moins une couche semi-conductrice. Chaque couche de la première structure planaire absorbante est agencée selon une structure cristalline de mailles. La première structure planaire absorbante est dopée N et réalisée par épitaxie sur un substrat et la composition des matériaux utilisés pour réaliser l'au moins une couche de la première structure planaire absorbante est choisie tel que :

- la première structure planaire absorbante présente une bande de valence effective formée par une pluralité de niveaux d'énergie. Chaque niveau d'énergie est occupé par l'un parmi :

    ○ un premier type de porteurs de charges positives dénommé trous lourds présentant une première masse effective ;
    ou
    ○ un second type de porteurs de charges positives dénommé trous légers présentant une seconde masse effective strictement inférieure à la première masse effective.

Le niveau d'énergie maximal de la bande de valence effective est occupé par des trous légers selon l'axe du pixel;

La structure cristalline de mailles de ladite couche ne présente pas de dislocations résultant d'une relaxation mécanique desdites mailles. La masse effective des porteurs de charges positives selon l'axe du pixel est inférieure à la moitié de la masse effective des porteurs de charges positives selon des directions définissant un plan orthogonal à l'axe du pixel.

Selon un aspect particulier de l'invention, le substrat est arrangé selon une structure cristalline de mailles et la composition des matériaux utilisés pour réaliser l'au moins une couche de la première structure planaire absorbante est choisie tel que :

- les mailles de l'au moins une couche formant ladite structure planaire absorbante subissent des contraintes mécaniques internes pour s'adapter aux mailles de la structure cristalline du substrat ;
- et tel que la contrainte résultante de la somme des contraintes mécaniques internes est une contrainte de tension.

Selon un aspect particulier de l'invention, la masse effective des trous porteurs de charges positives selon l'axe du pixel est inférieure au dixième de la masse d'un électron libre.

Selon un aspect particulier de l'invention, la différence entre le niveau d'énergie maximal occupé par des trous légers et le niveau d'énergie maximal occupé par des trous lourds est supérieure au produit de la constante de Boltzmann par la température de fonctionnement.

Selon un aspect particulier de l'invention, la composition des matériaux utilisés pour réaliser l'au moins une couche de la première structure planaire absorbante est choisie tel que l'amplitude la contrainte résultante de la somme des contraintes mécaniques internes est inférieure à une contrainte limite de dislocation prédéterminée. La densité de dislocations dans la première structure planaire absorbante étant strictement inférieure à $10^4$ dislocations/cm2.

Selon un aspect particulier de l'invention, la première structure planaire absorbante est constituée d'une seule couche en un matériau massif semi-conducteur de type III-V.

Selon un aspect particulier de l'invention, le matériau massif semi-conducteur est l'alliage quaternaire $Ga_{x1}In_{1-x1}As_{y1}Sb_{1-y1}$ avec x1 la fraction molaire de gallium dans l'alliage $Ga_{x1}In_{1-x1}As_{y1}Sb_{1-y1}$ et y1 la fraction molaire d'arsenic dans l'alliage $Ga_{x1}In_{1-x1}As_{y1}Sb_{1-y1}$ .

Selon un aspect particulier de l'invention :

- le substrat est réalisé en antimoniure de gallium GaSb ;
- la fraction molaire x1 de gallium Ga dans l'alliage $Ga_{x1}In_{1-x1}As_{y1}Sb_{1-y1}$ est comprise entre 0 et 1 ;
- et la fraction molaire y1 d'arsenic As dans l'alliage $Ga_{x1}In_{1-x1}As_{y1}Sb_{1-y1}$ est comprise entre une valeur minimale et une valeur maximale tel que :

    ◦ la valeur minimale est une fonction affine de la fraction molaire x1 de gallium Ga dans l'alliage $Ga_{x1}In_{1-x1}As_{y1}Sb_{1-y1}$ caractérisée par un coefficient directeur égal à -0,92 et une ordonnée à l'origine égale à 0,93
    ◦ la valeur maximale de la fraction molaire y1 d'arsenic As dans l'alliage $Ga_{x1}In_{1-x1}As_{y1}Sb_{1-y1}$ est une fonction affine de la fraction molaire x1 de gallium Ga dans l'alliage $Ga_{x1}In_{1-x1}As_{y1}Sb_{1-y1}$ caractérisée par un coefficient directeur égal à -0,92 et une ordonnée à l'origine égale à 0,97.

Selon un aspect particulier de l'invention :

- Le substrat est réalisé en antimoniure d'indium InSb ;
- et la fraction molaire x2 de gallium Ga dans le matériau massif semi-conducteur est comprise entre 0,02 et 0,05 ;
- et la fraction molaire y2 d'arsenic As dans le matériau massif semi-conducteur est comprise entre 0,02 et 0,05 .

Selon un aspect particulier de l'invention, la première structure planaire absorbante comprend un premier super-réseau comprenant un empilement le long de l'axe du pixel d'un groupe élémentaire de couches semi-conductrices comprenant :

- une première couche en un premier matériau semi-conducteur présentant

    ◦ une première valeur de minimum de bande de conduction ;
    ◦ une première valeur de maximum de bande de valence ;
    ◦ une première valeur de gap d'énergie ;

- au moins une deuxième couche en un deuxième matériau semi-conducteur présentant :

    ◦ une deuxième valeur de minimum de bande de conduction strictement inférieure à la première valeur de minimum de bande de conduction ;
    ◦ une deuxième valeur de maximum de bande de valence strictement inférieure à la première valeur de maximum de bande de valence ;
    ◦ et une deuxième valeur de gap d'énergie .

Les mailles de la première couche subissent des contraintes de tension et les mailles de la deuxième couche subissent des contraintes de compression.

Selon un aspect particulier de l'invention, le premier super-réseau présente une première valeur de maximum de bande de valence effective et les porteurs de charges positives dans la première couche d'un groupe élémentaire voient une barrière d'énergie égale à la différence entre :

- le niveau d'énergie maximal de la bande de valence effective occupé par des trous lourds ;
- et une première valeur de maximum de bande de valence effective .

Le produit de ladite barrière d'énergie par l'épaisseur de la deuxième couche est inférieur à une valeur prédéterminée.

Selon un aspect particulier de l'invention, le deuxième matériau semi-conducteur est l'alliage ternaire $InAs_{y3}Sb_{1-y3}$ avec y3 la fraction molaire d'arsenic dans l'alliage $InAs_{y3}Sb_{1-y3}$.

Selon un aspect particulier de l'invention, le premier matériau semi-conducteur est l'alliage quaternaire $Ga_{x3}In_{1-x3}As_{y4}Sb_{1-y4}$ avec x3 la fraction molaire de gallium dans l'alliage $Ga_{x3}In_{1-x3}As_{y4}Sb_{1-y4}$ et y4 la fraction molaire d'arsenic dans l'alliage $Ga_{x3}In_{1-x2}As_{y4}Sb_{1-y4}$.

Selon un aspect particulier de l'invention :

- la fraction molaire y3 d'arsenic dans l'alliage $InAs_{y3}Sb_{1-y3}$ est comprise entre 0,6 et 0,88.
- la fraction molaire x3 de gallium dans l'alliage $Ga_{x3}In_{1-x3}As_{y4}Sb_{1-y4}$ est comprise entre 0,2 et 0,5
- et la fraction molaire y4 d'arsenic dans l'alliage $Ga_{x3}In_{1-x3}As_{y4}Sb_{1-y4}$ est comprise entre une valeur minimale et une valeur maximale tel que :

  ○ la valeur minimale de la fraction molaire y4 d'arsenic dans l'alliage $Ga_{x3}In_{1-x3}As_{y4}Sb_{1-y4}$ étant une fonction affine de la fraction molaire x3 de gallium dans l'alliage $Ga_{x3}In_{1-x3}As_{y4}Sb_{1-y4}$ caractérisée par un coefficient directeur égal à -0,92 et une ordonnée à l'origine égale à 0,93.
  ○ la valeur maximale de la fraction molaire y4 d'arsenic dans l'alliage $Ga_{x3}In_{1-x3}As_{y4}Sb_{1-y4}$ étant une fonction affine de la fraction molaire x3 de gallium dans l'alliage $Ga_{x3}In_{1-x3}As_{y4}Sb_{1-y4}$ caractérisée par un coefficient directeur égal à -0,66 et une ordonnée à l'origine égale à 1,13.

Selon un aspect particulier de l'invention, la première structure planaire absorbante présente une première valeur de maximum de bande de valence effective , une première valeur de minimum de bande de conduction effective et une première valeur de gap d'énergie effectif. Le pixel comprend le long de son axe dans cet ordre :

- le substrat ;

- Une structure de contact inférieur en un troisième matériau semi-conducteur ou en un super-réseau de contact inférieur, dopée N+ et présentant :

  ○ une valeur de maximum de bande de valence de contact inférieur strictement inférieure à la valeur de maximum de bande de valence effective de la première structure planaire absorbante;
  ○ et une valeur de gap d'énergie de contact inférieur supérieure ou égale à la première valeur de gap d'énergie effectif de la première structure planaire absorbante .

- Une structure planaire absorbante globale comprenant :
la première structure planaire absorbante; les couches de ladite première structure planaire absorbante étant dopées N ;
- une ou plusieurs structures de transition. la structure de transition en contact avec la structure planaire absorbante globale est dénommée structure de transition initiale. La structure de transition initiale est réalisée en un quatrième matériau semi-conducteur ou en un premier super-réseau de la structure de transition, dopée N et présentant :

  ○ une valeur de maximum de bande de valence de la structure de transition initiale strictement supérieure à la valeur de maximum de bande de valence effective de la première structure planaire absorbante;
  ○ et une valeur de gap d'énergie de la structure de transition initiale strictement supérieure à la première valeur de gap d'énergie effectif de la première structure planaire absorbante .

- Une structure de contact supérieur en un cinquième matériau semi-conducteur ou en un super-réseau de contact supérieur, dopée P+ et présentant :

  ○ une valeur de maximum de bande de valence de contact supérieur strictement supérieure à la valeur de maximum de bande de valence de chaque structure de transition ;
  ○ et une valeur de gap d'énergie de contact supérieur strictement supérieure à la valeur de gap d'énergie de chaque structure de transition.

Selon un aspect particulier de l'invention , le pixel comprend plusieurs structures de transition de rang i=1 à N croissant en partant de la structure planaire absorbante globale vers structure de contact supérieur, avec N un entier naturel non nul, tel que :

- chaque structure de transition de rang i=2 à N présente une valeur de maximum de bande de valence strictement supérieure à la valeur de maximum de bande de valence de la structure de transition de rang i-1 .

D'autres caractéristiques et avantages de la présente invention apparaîtront mieux à la lecture de la description qui suit en relation aux dessins annexés suivants.

[Fig. 1a] la figure 1a illustre une vue en perspective d'un premier exemple de pixel appartenant à un détecteur matriciel dans le domaine de fréquences infrarouges.

[Fig. 1b] la figure 1b illustre une vue en perspective d'un second exemple de pixel appartenant à un détecteur matriciel dans le domaine de fréquences infrarouges.

[Fig. 2a] la figure 2a illustre une vue en coupe d'un pixel détecteur infrarouge comprenant une structure planaire d'absorption selon un premier mode de réalisation de l'invention.

[Fig. 2b] la figure 2b illustre des plages de valeurs de fractions molaires pour le choix des compositions de matériaux de la structure planaire d'absorption selon le premier mode de réalisation de l'invention.

[Fig. 2c] la figure 2c illustre un diagramme bandes simulé de la structure planaire absorbante selon le premier mode de réalisation de l'invention dans les trois directions de l'espace vectoriel réciproque.

[Fig. 2d] la figure 2d illustre un schéma de la structure des bandes de la structure planaire absorbante selon le premier mode de réalisation de l'invention dans la direction de l'axe du pixel à $k_z=0$.

[Fig. 3a] la figure 3a illustre une vue en coupe d'un pixel détecteur infrarouge comprenant une structure planaire d'absorption selon un second mode de réalisation de l'invention.

[Fig. 3b] la figure 3b illustre des plages de valeurs de fractions molaires pour le choix des compositions de matériaux de la structure planaire d'absorption selon le second mode de réalisation de l'invention.

[Fig. 3c] la figure 3c illustre un diagramme de mini-bandes simulé de la structure planaire absorbante selon le second mode de réalisation de l'invention dans les trois directions de l'espace vectoriel réciproque à $k_z=0$.

[Fig. 3d] la figure 3d illustre un schéma de la structure des bandes de la structure planaire absorbante selon le second mode de réalisation de l'invention dans la direction de l'axe du pixel.

[Fig. 4a] la figure 4a illustre une vue en coupe d'un premier exemple de pixel comportant une structure planaire absorbante selon l'un quelconque des modes de réalisation de l'invention.

[Fig. 4b] La figure 4b illustre un schéma de la structure de bandes selon l'axe du pixel de la figure 4a.

[Fig. 5] La figure 5 illustre une vue en coupe d'un dispositif de détection de rayonnements infrarouges comprenant une pluralité de pixels selon l'invention.

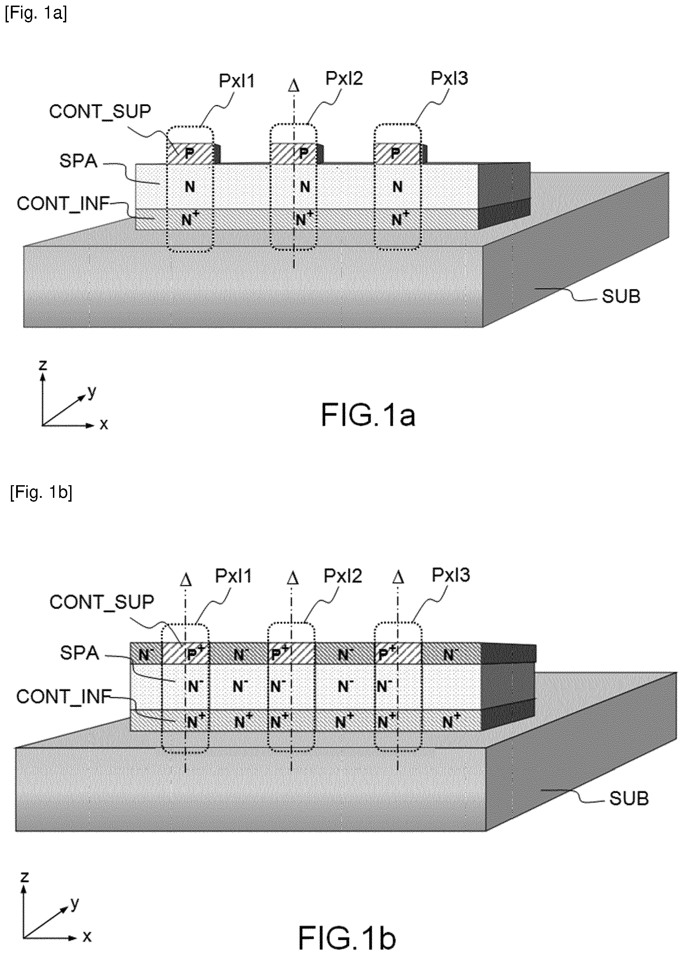

La figure 1a illustre une vue en perspective d'un exemple de pixel appartenant à un détecteur matriciel de rayonnements infrarouges. L'illustration est limitée à un seul pixel Pxl par souci de simplification mais elle n'exclut pas l'intégration du pixel dans une matrice comprenant une pluralité de pixels juxtaposés.
Le pixel Pxl d'un détecteur infrarouge est réalisé par un empilement de couches en matériaux semi-conducteurs formant la structure du pixel sur un substrat SUB. L'axe du pixel Δ est l'axe perpendiculaire au plan horizontal (x,y) formé par la surface supérieure du substrat SUB. Le substrat SUB est réalisé en un matériau massif semi-conducteur de type III-V par exemple. Le choix du matériau du substrat SUB est important car déterminant la technologie des étapes du procédé de fabrication du dispositif mais aussi les caractéristiques techniques (optiques, électriques, mécaniques...) du détecteur matriciel. Le pixel Pxl comprend les couches suivantes, en partant du substrat, selon la direction de l'axe du pixel Δ : une structure de contact inférieur CONT_INF, une structure planaire absorbante SPA et une structure de contact supérieure CONT_SUP.
La structure de contact inférieur CONT_INF peut être réalisée en matériau massif semi-conducteur dopé N+ et présente un niveau maximum d'énergie de la bande de valence inférieur au niveau maximum d'énergie de la bande de valence de la structure planaire absorbante SPA. Préférentiellement, le matériau constituant la structure de contact inférieur est de type III-V tel que, à titre d'exemple, l'arséniure de gallium, arséniure d'indium, nitrure de gallium, antimoniure de gallium, phosphure de bore, ainsi que leurs alliages ternaires ou quaternaires ou quinaires. Le contact inférieur CONT_INF peut également être réalisé avec des hétérostructures obtenues par un empilement d'une pluralité de couches fines de matériaux semi-conducteurs préférentiellement de type III-V tel que, à titre d'exemple, l'arséniure de gallium, arséniure d'indium, nitrure de gallium, antimoniure de gallium, phosphure de bore, ainsi que leurs alliages ternaires ou quaternaires ou quinaires. La structure de contact inférieur CONT_INF constitue à titre d'exemple un super-réseau dopé N+ présentant une grande valeur de gap d'énergie. On cite à titre d'exemple le super-réseau InAS/InAsSb dopé N+ ou le super-réseau InAs/InGaAsSb dopé N+.

La structure planaire absorbante SPA joue le rôle de zone absorbante. Elle est réalisée en matériau massif semi-conducteur dopé N (ou une hétéro structure de type super-réseau) présentant une valeur de gap d'énergie inférieure ou égale à celle de la structure de contact inférieur. Les caractéristiques du diagramme de bandes de la structure planaire absorbante SPA (bande de valence, bande de conduction, énergie de gap) sont intrinsèques dans le cas d'un matériau massif, ou effectives résultant de la combinaison des différentes couches fines dans le cas d'un super-réseau. La structure planaire absorbante SPA convertit le flux de photons incidents avec une longueur d'onde $\lambda$ en porteurs de charge négative « électrons » dans la bande de conduction (intrinsèque ou effective) de la structure SPA et de charge positive « trous » dans la bande de valence (intrinsèque ou effective) de la structure SPA. Pour les dispositifs visés par l'invention, il s'agit d'un effet photoélectrique où les porteurs de charges minoritaires (les trous pour un dopage N) sont utilisés pour générer le signal de lecture suite à la stimulation de structure planaire absorbante SPA par un rayonnement infrarouge. Les matériaux semi-conducteurs utilisés pour réaliser la structure planaire absorbante SPA (sous forme de matériau massif ou super-réseau) peuvent être de type III-V tel que, à titre d'exemple, l'arséniure de gallium, arséniure d'indium, nitrure de gallium, antimoniure de gallium, phosphure de bore, ainsi que leurs alliages ternaires ou quaternaires ou quinaires. La structure des bandes d'énergie dans la structure planaire absorbante SPA est déterminante pour augmenter la fréquence de coupure du détecteur matriciel comprenant le pixel Pxl.

La structure de contact supérieure CONT_SUP est réalisée en matériaux massifs semi-conducteur dopé P+ présentant généralement une grande valeur de gap d'énergie. Ces matériaux sont préférentiellement de type III-V tel que, à titre d'exemple, l'arséniure de gallium, arséniure d'indium, nitrure de gallium, antimoniure de gallium, phosphure de bore, ainsi que leurs alliages ternaires ou quaternaires ou quinaires. Le contact supérieur CONT_SUP peut également être réalisé avec des hétérostructures obtenues par un empilement d'une pluralité de couches fines de matériaux semi-conducteurs préférentiellement de type III-V tel que, à titre d'exemple, l'arséniure de gallium, arséniure d'indium, nitrure de gallium, antimoniure de gallium, phosphure de bore, ainsi que leurs alliages ternaires ou quaternaires ou quinaires. La structure de contact supérieur CONT_SUP constitue à titre d'exemple un super-réseau dopé P+ présentant une grande valeur de gap d'énergie.

La figure 1a illustre un pixel présentant une structure obtenue par des opérations successives de dépôt et gravure. Un pixel est ainsi délimité selon le plan (x,y) par sa structure tridimensionnelle obtenue par les opérations de gravure.

Alternativement, il est possible de réaliser la même architecture du pixel selon l'axe du pixel $\Delta$ mais délimitée selon le plan (x,y) avec des zones de dopage et non une structure résultat de gravure.

La figure 1b illustre une vue en perspective d'une pluralité de pixels appartenant à un détecteur matriciel dans le domaine de fréquences infrarouges délimités par les zones de dopage P+ du contact supérieur CONT_SUP. Les caractéristiques des différentes parties de chaque pixel selon son axe $\Delta$ restent les mêmes par rapport à la figure 1a. La différence majeure consiste en la manière de délimitation des pixels dans la matrice découlant du procédé de fabrication utilisé pour la délimitation (gravure en 1a et dopage du contact supérieur en 1b).

Comme indiqué précédemment, le choix des compositions des alliages semiconducteurs utilisés pour réaliser la structure planaire d'absorption est déterminant pour obtenir le point optimal recherché en terme de rendement quantique, réduction de la diaphonie et réduction du courant d'obscurité.

Pour comprendre l'invention, il est indispensable de comprendre le mécanisme de croissance d'une couche mince en accord de maille avec un substrat. D'une façon générale, un matériau massif à l'état solide est organisé selon une structure cristalline obtenue par la répétition spatialement périodique d'une maille élémentaire composée par les atomes dudit matériau. Pour un matériau donné, l'ensemble des caractéristiques mécaniques, physiques, électriques est déterminé entre autres par la structure de la maille cristalline. Pour le cas d'un alliage de matériaux semi-conducteurs, le choix des fractions molaires des différents matériaux qui composent l'alliage définit la structure cristalline et les paramètres géométriques de la maille cristalline de l'alliage obtenu.

Dans le cas des détecteurs de rayonnements infrarouges à base de couches minces semi-conductrices, la fabrication des couches qui forment la structure planaire absorbante est réalisée via le procédé d'épitaxie sur un substrat. Il est possible d'utiliser l'épitaxie par jets moléculaires ou l'épitaxie en phase vapeur aux organométalliques. Dans le cas d'un alliage semi-conducteur, le choix des fractions molaires utilisées dans l'étape d'épitaxie de chaque composant de l'alliage permet de contrôler les paramètres de la maille cristalline de la couche déposée. Ainsi, avec un choix judicieux des fractions molaires, il est possible de réaliser un dépôt par épitaxie d'une couche mince en accord de maille avec la structure cristalline du substrat. On parle ici, d'une hétéro-épitaxie.

Dans le cas où les fractions molaires utilisées dans l'alliage déposé sur le substrat sont différentes des valeurs correspondant à un accord de maille, il est possible de croitre des couches d'alliage semi-conducteur de quelques nanomètres sur le substrat, En effet, les mailles cristallines d'une couche déposée vont s'adapter à la maille cristalline du substrat lors de l'opération d'épitaxie en subissant des contraintes mécaniques internes. Les contraintes mécaniques internes peuvent être des contraintes de tension ou de compression selon les fractions molaires choisies de l'alliage. À l'échelle du réseau cristallin, les contraintes mécaniques internes subies par les mailles cristallines de la couche déposée engendrent des asymétries dans lesdites mailles et des modifications des forces électromagnétiques entre les atomes. D'un point de vue électrique, cela engendre une modification de la structure de bandes énergétiques dans la couche déposée.

D'une façon générale, dans un empilement de couches déposées sur un substrat par épitaxie, on distingue deux types de dislocations qui peuvent apparaitre dans le réseau cristallin des couches déposées : *les dislocations du substrat* et *les dislocations de relaxation.*

Les *dislocations du substrat* proviennent des dislocations intrinsèques dans le réseau cristallin du substrat avec une densité volumique de dislocation qui dépend du procédé de fabrication du substrat. Les dislocations du substrat comprennent des dislocations caractérisées par leur vecteur de Burgers incliné par rapport à l'interface avec un angle de 60°. Les dislocations à 60° peuvent se propager dans le volume de l'empilement jusqu'à la surface de la couche déposée par épitaxie. On parle de dislocations émergentes ou dislocations de filetage (traduction du terme anglais threading dislocations). Les dislocations du substrat présentent une densité volumique de l'ordre de 1 à $10^4$ dislocations/cm2 selon la maturité du procédé technologique. A titre d'exemple, la densité volumique des dislocations de substrat présentes dans un substrat en InP sont inférieure à $5.10^3$ dislocations/cm2.

*Les dislocations de relaxation* sont des dislocations liées au désaccord de mailles entre une couche déposée par épitaxie et le substrat SUB. En effet, lorsque les contraintes internes appliquées sur les mailles de la couche déposée dépassent une valeur seuil, un phénomène de relaxation mécanique d'une partie des mailles se produit. L'énergie élastique des mailles de l'empilement de couches ne permet plus de supporter la contrainte, une pluralité de *dislocations de relaxation* émergentes et non émergentes apparaît dans le volume du réseau cristallin. Ce phénomène est déterminé alors indirectement par la composition choisie des alliages déposés par épitaxie par rapport au substrat. Dans le cas du dépassement de la contrainte limite de relaxation, la densité volumique de dislocations devient de l'ordre de $10^7$ à $10^{10}$ dislocations/cm2. Dans le cas du détecteur infrarouge réalisé par épitaxie, la relaxation mécanique engendre des dislocations qui se propagent dans le volume de la structure d'absorption fragilisant mécaniquement l'ensemble de la structure du pixel et dégradant les performances électro-optiques du pixel.

Dans les paragraphes qui suivent nous allons décrire les différents modes de réalisation de l'invention.

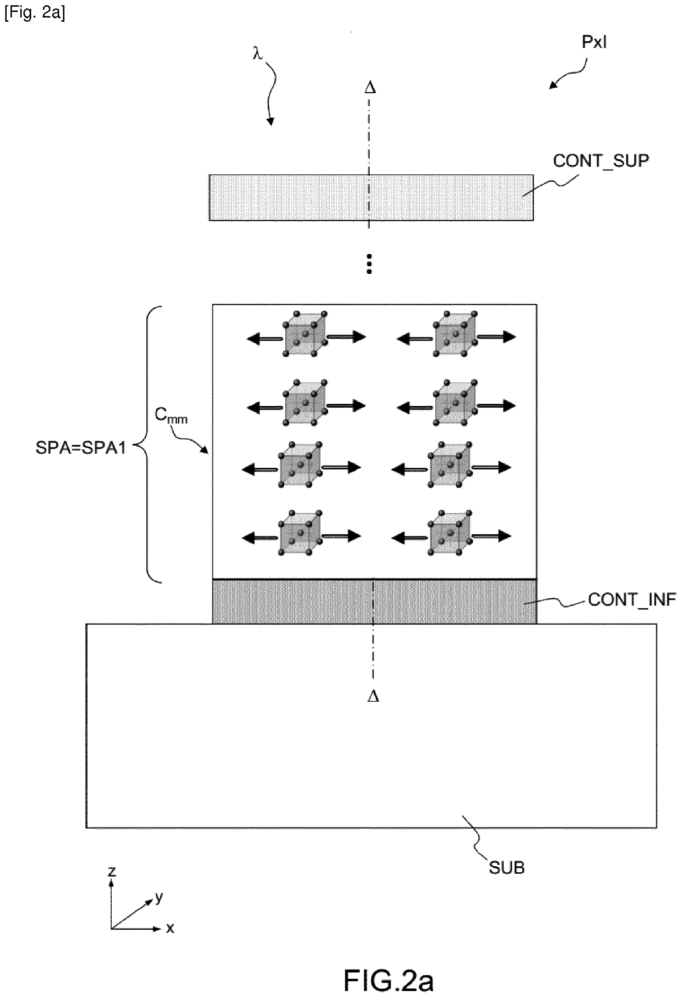

La figure 2a illustre une vue en coupe d'un pixel détecteur infrarouge comprenant une structure planaire d'absorption selon un premier mode de réalisation de l'invention. Il s'agit dans ce cas d'une structure planaire d'absorption réalisée avec une couche en matériau massif $C_{mm}$.

La couche en matériau massif $C_{mm}$ est déposée par épitaxie sur le substrat SUB avec un désaccord des paramètres de mailles engendrant des contraintes internes sur les mailles de la couche absorbante $C_{mm}$ tel que représenté par les flèches sur la figure 2a. La couche en matériau massif $C_{mm}$ est dopée N et c'est les porteurs de charges minoritaires qui constituent le signal électrique photo généré. De plus, les contraintes internes subies par les mailles engendrent un phénomène quantique connu par le terme « levée de la dégénérescence ».

La « levée de la dégénérescence » consiste en une séparation du niveau d'énergie de la bande de valence dite de « trou lourd » et celle dite de « trou léger » en k=0. Une bande de valence est dite de « trou lourd » lorsque sa relation de dispersion est faible. Une bande de valence est dite de « trou léger » lorsque sa relation de dispersion est forte. Une bande de valence dite de « trou lourd » est ainsi occupée par les trous lourds et une bande de valence dite de « trou léger » est occupée par les trous légers. Dans un matériau semi-conducteur, les trous légers présentent une masse effective $m_{lh}$ largement inférieure à celle des trous lourds notée $m_{hh}$. On obtient ainsi dans la couche en matériau massif $C_{mm}$ en k=0 la distinction entre un niveau d'énergie maximal de bande de valence occupée par les trous lourds et un niveau d'énergie maximal de bande de valence occupée par les trous légers. De plus, une modification de la position de la bande de conduction et des bandes de valence se produit sous l'effet de la contrainte. Quand il s'agit d'une contrainte de tension, le gap d'énergie diminue (minimum de la bande de conduction diminue et maximum de la bande de valence augmente). Quand il s'agit d'une contrainte de compression, le gap d'énergie augmente (minimum de la bande de conduction augmente et maximum de la bande de valence diminue).

La couche en matériau massif $C_{mm}$ dopée N est réalisée par un alliage de matériaux semi-conducteurs de type III-V, et les fractions molaires sont choisies tel que la contrainte résultante de la somme des contraintes mécaniques internes est une contrainte de tension. Cette contrainte globale de tension sur l'ensemble de la couche en matériau massif entraine l'obtention d'une bande de valence dite de « trou léger » la plus haute en énergie selon l'axe du pixel et une bande de valence dite de « trou lourd » la plus haute en énergie selon le plan normal (x,y). Il y a génération d'une asymétrie entre : d'une part, la masse effective des trous selon l'axe du pixel $m_z$ majoritairement des trous légers et d'autre part la masse effective des trous selon le plan normal au pixel $m_{x,y}$ majoritairement des trous lourds. L'asymétrie de masses effectives (et donc de mobilité) engendre une mobilité des trous selon l'axe du pixel plus grande que dans le plan normal (x,y).

La faible masse effective $m_z$ des porteurs de charges minoritaires dans la structure planaire d'absorption selon l'axe du pixel Δ assure un meilleur rendement quantique du pixel Pxl détecteur. La mobilité des porteurs de charges positives selon l'axe du pixel dans la structure d'absorption du premier mode de réalisation est multipliée par 20 par rapport à une structure ou il n'y pas inversement entre les niveaux énergétique des trous lourds et des trous légers.

La grande masse effective $m_{x,y}$ des porteurs de charges minoritaires dans la structure planaire d'absorption dans le plan normal (x,y) réduit le phénomène de diaphonie entre les pixels adjacents. L'asymétrie entre les masses effectives des trous permet de réduire la diaphonie pour des distances entre pixels inférieures à $15\mu m$.

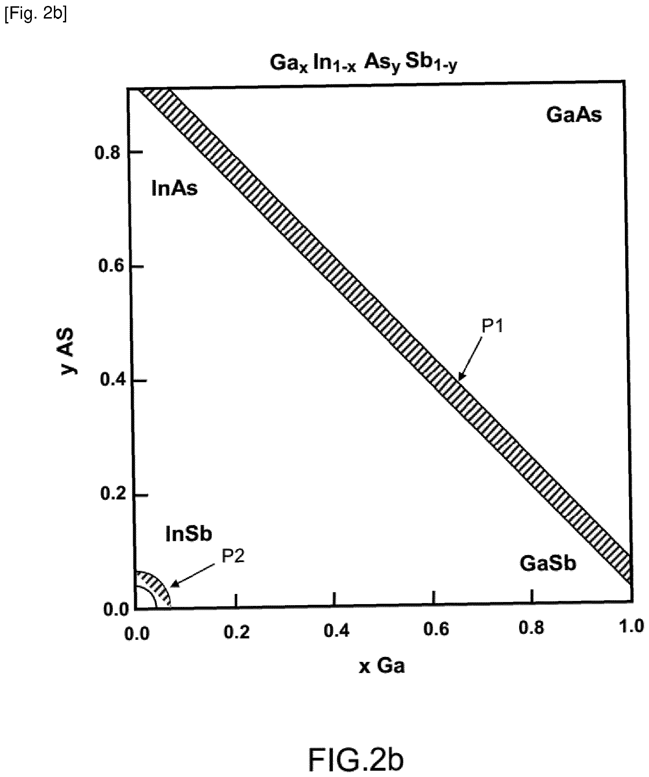

La figure 2b illustre des plages de valeurs de fractions molaires utilisées pour le choix des compositions de matériaux de la structure planaire d'absorption selon le premier mode de réalisation de l'invention.

La structure planaire d'absorption SPA présentant les caractéristiques détaillées précédemment peut être obtenue par le dépôt d'une couche $C_{mm}$ réalisée avec l'alliage $Ga_x In_{1-x} As_y Sb_{1-y}$ sur un substrat en GaSb. On note x1 la fraction molaire de gallium Ga dans le dans l'alliage $Ga_x In_{1-x} As_y Sb_{1-y}$ et y1 la fraction molaire y d'arsenic As dans l'alliage $Ga_x In_{1-x} As_y Sb_{1-y}$. L'ensemble des couples de fractions molaires (x1,y1) définissent la surface P1 décrite dans le diagramme de la figure 2b correspondant à la plage des compositions qui permettent d'obtenir une structure planaire d'absorption SPA avec :

- La contrainte globale sur les mailles de la couche $C_{mm}$ est une contrainte de tension.

- Une asymétrie entre la bande de valence selon l'axe du pixel ayant un niveau d'énergie maximal occupé par des trous légers et la bande de valence selon le plan (x,y) ayant un niveau d'énergie maximal occupé par des trou lourds.

- Une faible densité de dislocations grâce à l'absence des dislocations de relaxation.

La plage de composition P1 est définie par les règles suivantes :

- la fraction molaire x1 de gallium Ga dans le dans l'alliage $Ga_{x1} In_{1-x1} As_{y1} Sb_{1-y1}$ est comprise entre 0 et 1 ;

$$0 \leq x1 \leq 1$$

- et la fraction molaire y1 d'arsenic As dans l'alliage $Ga_{x1} In_{1-x1} As_{y1} Sb_{1-y1}$ est comprise entre une valeur minimale $y1_{min}$ et une valeur maximale $y1_{max}$ tel que :

$$y1_{min} \leq y1 \leq y1_{max}$$

- la valeur minimale $y1_{min}$ de la fraction molaire y1 d'arsenic As dans l'alliage $Ga_{x1} In_{1-x1} As_{y1} Sb_{1-y1}$ est une fonction affine de la fraction molaire x1 de gallium Ga dans l'alliage $Ga_{x1} In_{1-x1} As_{y1} Sb_{1-y1}$ caractérisée par un coefficient directeur égal à -0,92 et une ordonnée à l'origine égale à 0,93 ;

$$y1_{min} = -0,92x1 + 0,93$$

- la valeur maximale $y1_{max}$ de la fraction molaire y1 d'arsenic As dans l'alliage $Ga_{x1} In_{1-x1} As_{y1} Sb_{1-y1}$ est une fonction affine de la fraction molaire x1 de gallium Ga dans l'alliage $Ga_{x1} In_{1-x1} As_{y1} Sb_{1-y1}$ caractérisée par un coefficient directeur égal à -0,92 et une ordonnée à l'origine égale à 0,97 ;

$$y1_{max} = -0,92x1 + 0,97$$

Alternativement, la structure planaire d'absorption SPA présentant les caractéristiques détaillées précédemment peut être obtenue par le dépôt d'une couche $C_{mm}$ réalisée avec l'alliage $Ga_x In_{1-x} As_y Sb_{1-y}$ sur un substrat en InSb. L'ensemble des couples de fractions molaires (x2,y2) définissent l'arc de disque P2 décrit dans le diagramme de la figure 2b correspondant à la plage des compositions permettent d'obtenir une structure planaire d'absorption SPA sur un substrat InSb avec :

- La contrainte globale sur les mailles de la couche $C_{mm}$ est une contrainte de tension.

- Une asymétrie entre la bande de valence selon l'axe du pixel ayant un niveau d'énergie maximal occupé par des trous légers et la bande de valence selon le plan (x,y) ayant un niveau d'énergie maximal occupé par des trou lourds.

- Une faible densité de dislocations grâce à l'absence des dislocations de relaxation.

La plage de composition P2 est définie par les règles suivantes :

- la fraction molaire x2 de gallium Ga dans l'alliage $Ga_{x2} In_{1-x2} As_{y2} Sb_{1-y2}$ est comprise entre 0,02 et 0,05 ;

$$0,02 \leq x2 \leq 0,05$$

- et la fraction molaire y2 d'arsenic As dans l'alliage $Ga_x In_{1-x1} As_{y1} Sb_{1-y1}$ est comprise entre est comprise entre 0,02 et 0,05 ;

$$0,02 \leq y2 \leq 0,05$$

Le choix des fractions molaires dans les plages P1 ou P2 selon le substrat utilisé permettent d'obtenir une structure planaire absorbante SPA sous une contrainte de tension notée $c_{tot}$ sans dépasser la valeur limite de 4000 ppm pouvant engendrer la relaxation du matériau de la couche $C_{mm}$.

$$c_{tot} \leq 4000 \text{ ppm}$$

La contrainte de tension pour les choix d'alliages appartenant à la plage P1 sur un substrat GaSb est comprise entre 800 ppm et 4000 ppm. La contrainte de tension pour les choix d'alliages appartenant à la plage P2 sur un substrat InSb est comprise entre 500 ppm et 4000 ppm.

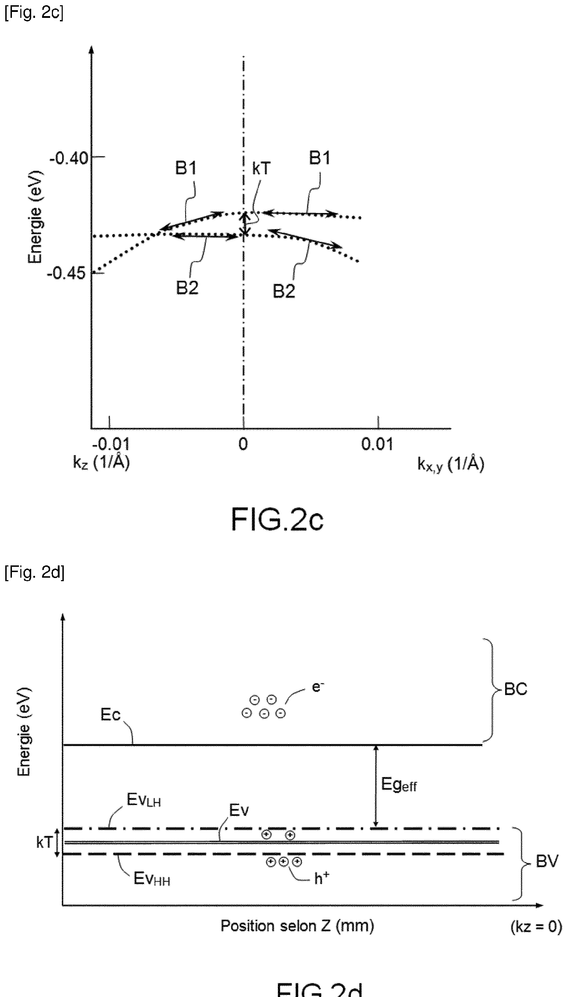

La figure 2c illustre un diagramme de bandes simulé d'un exemple de la structure planaire absorbante selon le premier mode de réalisation de l'invention dans les trois directions de l'espace vectoriel réciproque défini par k le vecteur d'ondes dans un matériau semi-conducteur. Plus spécifiquement, le diagramme simulé dans la figure 2c illustre le diagramme de bandes d'une couche $C_{mm}$ en $Ga_{0,05}In_{0,95}As_{0,885}Sb_{0,115}$ sur un substrat en GaSb.

Sous ces conditions, la structure planaire absorbante SPA subit une contrainte de tension de l'ordre de 1000ppm.. La densité de dislocations dans la structure absorbante SPA selon le premier mode de réalisation est de l'ordre de $10^3$ dislocations/cm2 car il n'y a pas de relaxation des matériaux. La structure planaire absorbante SPA avec cet exemple de composition permet d'atteindre une longueur d'onde de coupure de $\lambda c=4,2\mu m$ à une température de fonctionnement de T=150K avec une masse effective de trous selon l'axe du pixel $m_z=0,02\,m_0$ et une masse effective de trous dans le plan normal du pixel $m_{x,y}=0,4\,m_0$ avec $m_0$ la masse effective d'un électron libre.

Pour chaque niveau d'énergie dans la bande de valence, la masse effective des trous dans le diagramme de bandes est inversement proportionnelle à la pente de la variation du niveau d'énergie dans l'espace vectoriel réciproque. On observe ainsi sur le diagramme que selon la direction z (axe du pixel) le niveau d'énergie maximal de la bande de valence est occupé par des trous légers ($Ev_{lh}$). L'écart d'énergie $\Delta_{lh-hh}$ entre le niveau d'énergie maximal B1 occupé par les trous légers $Ev_{lh}$ et le niveau des trous lourds $Ev_{hh}$ est de l'ordre de $k_bT$ avec $k_b$ la constante de Boltzmann et T la température de fonctionnement. L'ensemble des combinaisons de compositions comprises dans la surface P1 ou P2 (selon le substrat) permettent d'obtenir des valeurs de $\Delta_{lh-hh}$ de l'ordre de $k_bT$ ou plus selon la température de fonctionnement et la fréquence de coupure visées.

Lorsqu'on regarde le diagramme de bande selon les directions kx et ky correspondant au plan normal du pixel, c'est une distribution inverse des trous qui est obtenue. En effet, le niveau d'énergie maximal B1 de la bande de valence selon le plan normal au pixel (x,y) est occupé par des trous lourds (avec une pente plus plate).

On obtient ainsi l'asymétrie entre la mobilité des porteurs de charges minoritaires (trous dans ce cas) entre l'axe du pixel et le plan normal au pixel permettant de réduire le phénomène de diaphonie sans réduire le rendement quantique de la zone absorbante.

La figure 2d illustre d'une façon générale un schéma de la structure des bandes de la structure planaire absorbante SPA selon le premier mode de réalisation de l'invention selon la direction de l'axe du pixel avec $k_z=0$.

La couche $C_{mm}$ est sous contrainte de tension et le phénomène de levée de dégénérescence s'observe par la distinction du niveau d'énergie maximal des trous lourds $Ev_{hh}$ et le niveau d'énergie maximal des trous légers $Ev_{lh}$ avec un écart de $k_bT$. Cette distribution favorise la circulation des trous légers car la création de couple électrons trous par effet photoélectrique par stimulation photonique requiert une énergie inférieure pour les trous légers.

Dans le paragraphe suivant nous allons donner des exemples de compositions préférentielles selon le premier mode de réalisation sur un substrat GaSb selon la fréquence de coupure et la température de fonctionnement visées :

- Pour $\lambda c=1,9\mu m$ et T entre 250K et 300K : $C_{mm}$ est réalisé en $Ga_xIn_{1-x}As_ySb_{1-y}$ avec $0,95\leq x\leq 0,98$ et $0,04\leq y\leq 0,08$ ;

- Pour $\lambda c=2,5\mu m$ et T entre 250K et 300K : $C_{mm}$ est réalisé en $Ga_xIn_{1-x}As_ySb_{1-y}$ avec $0,78\leq x\leq 0,84$ et $0,17\leq y\leq 0,22$ ;

- Pour $\lambda c=4,2\mu m$ et T=150K : $C_{mm}$ est réalisé en $Ga_xIn_{1-x}As_ySb_{1-y}$ avec $0,03\leq x\leq 0,07$ et $0,86\leq y\leq 0,9$.

Dans la section suivante nous allons décrire le deuxième mode de réalisation de l'invention basé sur une structure planaire d'absorption réalisée par un super-réseau.

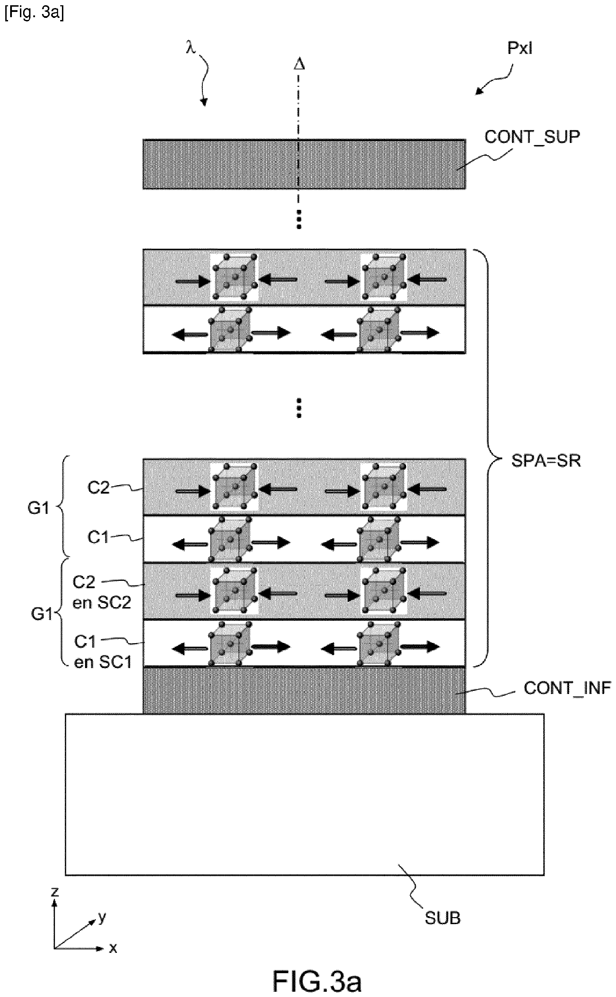

La figure 3a illustre une vue en coupe d'un pixel détecteur infrarouge comprenant une structure planaire d'absorption selon un second mode de réalisation de l'invention basé sur un super-réseau SR.

La structure planaire d'absorption SPA est réalisée dans cette illustration via une hétérostructure périodique qui forme le super réseau SR. D'une façon générale, le super-réseau SR est un empilement périodique d'un groupe élémentaire G1 formé par une pluralité de couches fines en matériaux semi-conducteurs. Dans cet exemple, le groupe élémentaire est formé par la première couche C1 ayant une épaisseur e1 et la deuxième couche C2 ayant une épaisseur e2. Ainsi, la période du super réseau est égale à e1+e2. D'un point de vue quantique, si les couches C1 et C1 sont suffisamment minces (entre 0,3 nm pour une monocouche atomique et 10nm), un phénomène de couplage quantique est obtenu au niveau des différentes jonctions aux interfaces des couches. Ce couplage quantique permet aux porteurs de charge d'accéder à des nouvelles mini-bandes d'énergies. Cela revient à l'obtention d'un diagramme de bandes d'énergie résultant différent de celui des matériaux massifs constitutifs du super réseau SR. Dans la suite du texte de cette demande, le diagramme de bandes d'énergie résultant de l'association des couches minces G1= (C1, C1) formant le super réseau SR est désigné par le « diagramme de bande effectif ».

Le diagramme de bande effectif est défini par :

- une bande de conduction effective, $BC_{eff}$ ayant une valeur d'énergie minimale $Ec_{eff}$.

- une bande de valence effective, $BV_{eff}$ ayant une valeur d'énergie maximale $Ev_{eff}$.

- un gap d'énergie effectif $Eg_{eff}$. égale à la différence entre la valeur d'énergie minimale de la bande de conduction $Ec_{eff}$ et la valeur d'énergie maximale $Ev_{eff}$.

D'une façon générale, l'utilisation des superréseaux dans les structures planaires absorbantes d'un pixel permet d'atteindre des fréquences de coupures non accessibles avec des zones d'absorption à base de matériaux massifs. Les choix de conception de la structure planaire absorbante SPA couvrent à titre non limitatif la composition des matériaux utilisés (ingénierie des matériaux), l'utilisation d'une structure à matériau massif ou super-réseau et les épaisseurs de couches utilisées (conception structurelle du dispositif). Ces choix de conception ouvrent des possibilités permettant d'améliorer le rendement quantique du pixel et la limitation des bruits de diaphonie « cross-talk » entre les pixels adjacents.

Pour réaliser le second mode de réalisation de l'invention, pour chaque groupe élémentaire G1 du super-réseau SR :

- La couche C1 est réalisée par un premier matériau semi-conducteur SC1 présentant une première valeur de minimum de bande de conduction $Ec1$ ; une première valeur de maximum de bande de valence $Ev1$ et une première valeur de gap d'énergie $Eg1$.

- La deuxième couche C2 est réalisée en un deuxième matériau semi-conducteur SC2 présentant une deuxième valeur de minimum de bande de conduction $Ec2$ strictement inférieure à la première valeur de minimum de bande de conduction $Ec1$ ; une deuxième valeur de maximum de bande de valence $Ev2$ strictement inférieure à la première valeur de maximum de bande de valence $Ev1$ et une deuxième valeur de gap d'énergie $Eg2$.

Les mailles de chaque couche C1 subissent des contraintes de tension, les mailles de chaque couche C2 subissent des contraintes de compression, la contrainte résultante de la somme des contraintes mécaniques internes pour chaque groupe élémentaire G1 est une contrainte de tension.

D'une façon générale, les mêmes caractéristiques électriques et mécaniques du premier mode de réalisation avec une couche $C_{mm}$ en matériau massif sont obtenues avec le second mode de réalisation avec un super réseau SR.

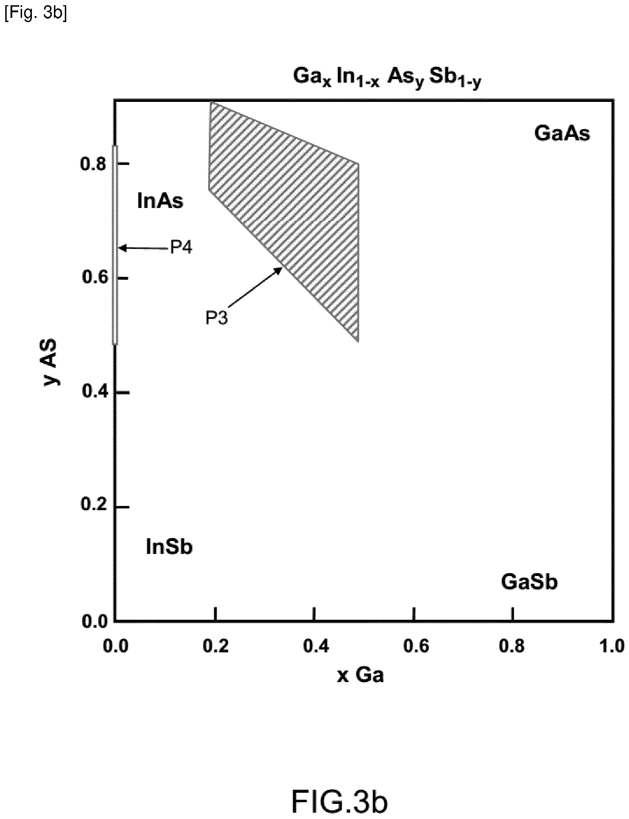

La figure 3b illustre des plages de valeurs de fractions molaires utilisées pour le choix des compositions de matériaux des couches C1 et C2 de la structure planaire d'absorption SPA selon le second mode de réalisation de l'invention.

La structure planaire d'absorption SPA présentant les caractéristiques détaillées précédemment peut s'obtenir par la fabrication d'un super réseau SR sur un substrat en GaSb avec un groupe élémentaire G1=(C1, C2) tel que la seconde couche C2 est réalisée avec l'alliage $InAs_{y3}Sb_{1-y3}$ avec y3 la fraction molaire d'arsenic dans l'alliage $InAs_{y3}Sb_{1-y3}$ comprise entre 0,6 et 0,88 (plage P4 sur le diagramme de compositions).

$$0,6 \leq y3 \leq 0,88$$

De plus, la première couche C1 est réalisée avec l'alliage $Ga_{x3}In_{1-x3}As_{y4}Sb_{1-y4}$. On note x3 la fraction molaire de gallium Ga dans le dans l'alliage $Ga_{x3}In_{1-x3}As_{y4}Sb_{1-y4}$. et y4 la fraction molaire y d'arsenic As dans l'alliage $Ga_{x3}In_{1-x3}As_{y4}Sb_{1-y4}$.. L'ensemble des couples de fractions molaires (x3, y4) définissent la surface P3 décrite dans le diagramme de la figure 3b.

La plage de composition P3 est définie par les inégalités suivantes :

- la fraction molaire x3 de gallium Ga dans le dans l'alliage $Ga_{x3}In_{1-x3}As_{y4}Sb_{1-y4}$ est comprise entre 0,2 et 0,5 ;

$$0,2 \leq x3 \leq 0,5$$

- et la fraction molaire y4 d'arsenic As dans l'alliage $Ga_{x3}In_{1-x3}As_{y4}Sb_{1-y4}$ est comprise entre une valeur minimale $y4_{min}$ et une valeur maximale $y4_{max}$ tel que :

$$y4_{min} \leq y4 \leq y4_{max}$$

- la valeur minimale $y4_{min}$ de la fraction molaire y4 d'arsenic As dans l'alliage $Ga_{x3}In_{1-x3}As_{y4}Sb_{1-y4}$ est une fonction affine de la fraction molaire x3 de gallium Ga dans l'alliage $Ga_{x3}In_{1-x3}As_{y4}Sb_{1-y4}$ caractérisée par un coefficient directeur égal à -0,92 et une ordonnée à l'origine égale à 0,93 ;

$$y4_{min} = -0,92x3 + 0,93$$

- la valeur maximale $y4_{max}$ de la fraction molaire y3 d'arsenic As dans l'alliage $Ga_{x3}In_{1-x3}As_{y4}Sb_{1-y4}$ est une fonction affine de la fraction molaire x3 de gallium Ga dans l'alliage $Ga_{x3}In_{1-x3}As_{y4}Sb_{1-y4}$ caractérisée par un coefficient directeur égal à -0,66 et une ordonnée à l'origine égale à 1,13 ;

$$y4_{max} = -0,66x1 + 1,13$$

Pour les couches C1 et C2 les plages des compositions (x3,y4) pour C1 et y3 pour C2 prises dans les plages P3 et P4 permettent d'obtenir une structure planaire d'absorption SPA avec :

- La contrainte globale sur les mailles du groupe élémentaire G1=(C1, C2) est une contrainte de tension.

- Une asymétrie entre la bande de valence selon l'axe du pixel ayant un niveau d'énergie maximal occupé par des trous légers et la bande de valence selon le plan (x,y) ayant un niveau d'énergie maximal occupé par des trou lourds.

- Une faible densité de dislocations grâce à l'absence des dislocations de relaxation.

Le choix des fractions molaires dans les plages P3 et P4 pour le super-réseau SR permettent d'obtenir une structure planaire absorbante SPA formée par la répétition de groupes élémentaires G1 tel que chaque groupe est sous une contrainte de tension sans dépasser la valeur limite de 4000 ppm pouvant engendrer la relaxation des matériaux des couches C1 et C2. Les contraintes et les épaisseurs de chaque couche C1, C2 du groupe élémentaire G1 doivent respecter l'inégalité suivante pour éviter les phénomènes de dislocation de relaxation :

$$\frac{\sum_i ei.ci}{\sum_i ei} \leq 4000 \, ppm$$

Avec $e_i$ l'épaisseur de la $i^{ème}$ couche Ci du groupe élémentaire G1, et $c_i$ la contrainte subie par les mailles de la $i^{ème}$ couche $C_i$ du groupe élémentaire G1. La densité de dislocations dans la structure absorbante SPA selon le second mode de réalisation est de l'ordre de $10^3$ dislocations/cm2 car il n'y a pas de relaxation des matériaux.

Pour tenir en compte de cette inégalité avec les plages de compositions détaillées dans la figure 3b, Il est envisageable de choisir l'épaisseur e1 de la première couche C1 entre 3nm et 6nm et l'épaisseur e2 de la seconde couche C2 entre 0,9nm et 2nm. Les faibles valeurs d'épaisseurs permettent de monter pour chaque couche Ci du groupe élémentaire G1 à des contraintes qui peuvent atteindre une amplitude de 20000 ppm pour chaque couche Ci individuellement.

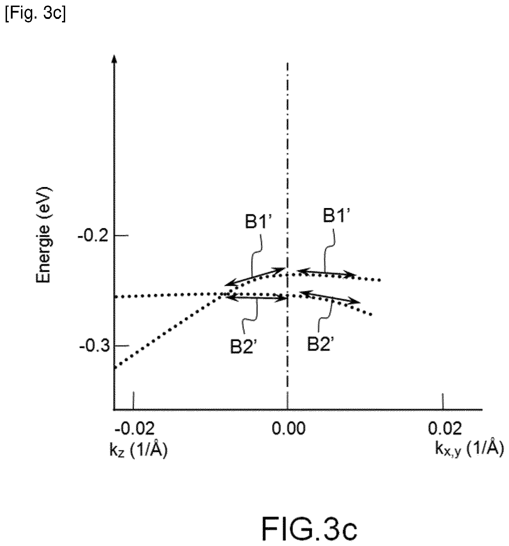

La figure 3c illustre un diagramme de bandes simulé d'un exemple de la structure planaire absorbante selon le second mode de réalisation de l'invention dans les trois directions de l'espace vectoriel réciproque définit par k le vecteur d'ondes dans un matériau semi-conducteur. Plus spécifiquement, le diagramme simulé dans la figure 3c illustre le diagramme de bandes du super réseau SR avec C1 en $Ga_{0,26}In_{0,74}As_{0,72}Sb_{0,28}$ et C2 en $InAs_{0,85}Sb_{0,15}$ en In sur un substrat en GaSb.

Sous ces conditions, la structure planaire absorbante SPA subit une contrainte de tension de l'ordre de 1000ppm.. La structure planaire absorbante SPA avec cet exemple de composition permet d'atteindre une longueur d'onde de coupure de $\lambda c=5\mu m$ à une température de fonctionnement de T=150K avec une masse effective de trous selon l'axe du pixel $m_z=0,02$ $m_0$ et une masse effective de trous dans le plan normal du pixel $m_{x,y}=0,4 \, m_0$ avec $m_0$ la masse effective d'un électron libre.

Pour chaque niveau d'énergie dans la bande de valence, la masse effective des trous dans le diagramme de bandes est inversement proportionnelle à la pente de la variation du niveau d'énergie dans l'espace vectoriel réciproque. Similairement à la figure 2c, on observe ainsi sur le diagramme que selon la direction z (axe du pixel) le niveau d'énergie maximal de la bande de valence est occupé par des trous légers. L'écart d'énergie $\Delta_{lh-hh}$ entre le niveau d'énergie maximal B'1 occupé par les trous légers et le niveau des trous lourds est de l'ordre de $k_b T$ avec $k_b$ la constante de Boltzmann et T la température de fonctionnement. L'ensemble des combinaisons de compositions prises parmi les intervalles P3 pour C1 et P4 pour C2 permettent d'obtenir des valeurs de $\Delta_{lh-hh}$ de l'ordre de $k_b T$ selon la température de fonctionnement et la fréquence de coupure visées.

De même, lorsqu'on regarde le diagramme de bande selon les directions kx et ky correspondant au plan normal du pixel, c'est une distribution inverse des trous qui est obtenue. En effet, le niveau d'énergie maximal B'1 de la bande de valence selon le plan normal au pixel (x,y) est occupé par des trous lourds (avec une pente plus plate).

On obtient ainsi l'asymétrie entre la mobilité des porteurs de charges minoritaires (trous dans ce cas) entre l'axe du pixel et le plan normal au pixel permettant de réduire le phénomène de diaphonie sans réduire le rendement quantique de la zone absorbante.

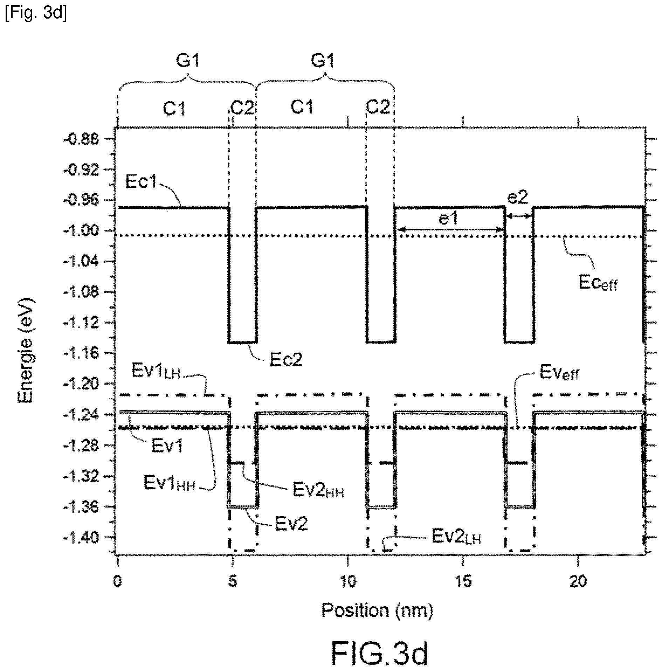

La figure 3d illustre un schéma de la structure des bandes de la structure planaire absorbante SPA selon le second mode de réalisation de l'invention selon la direction de l'axe du pixel avec $k_z=0$.

Les matériaux qui composent le super réseau sont choisis tel que Ec1>Ec2 et Ev1>Ev2 pour obtenir un diagramme de potentiel de type 2. Il s'agit d'une alternance de barrières de potentiel dans les deuxièmes couches C2 et de puits de potentiel dans les premières couches C1 vus par porteurs de charges positives. Il s'agit en outre d'une alternance de barrières de potentiel dans les premières couches C1 et de puits de potentiel dans les deuxièmes couches C2 vus par porteurs de charges négatives.

Comme indiqué précédemment, le couplage quantique entre les différentes couches du super-réseau engendre la création d'une bande de conduction effective avec un niveau d'énergie minimum effectif $Ec_{eff}$ et d'une bande de valence effective avec un niveau d'énergie maximum effectif $Ev_{eff}$. Le gap d'énergie effectif du super-réseau est défini par $Eg_{eff} = Ec_{eff} - Ev_{eff}$.

On définit la barrière de potentiel BAR vue par les trous confinés dans un puits de potentiel dans une hétérostructure de bandes de type 2 par la différence entre le niveau d'énergie maximum effectif $Ev_{eff}$ de la mini-bande de valence du super réseau SR et le maximum d'énergie de la bande de valence occupé par des trous lourds dans la couche C2 noté $Ev2_{hh}$ ;

$$BAR = Ev_{eff} - Ev2_{hh}$$

On définit β le produit de la barrière de potentiel BAR par l'épaisseur e2 de la couche C2 correspondant à l'épaisseur de barrière vue par un trou dans le volume du super réseau selon SR.

$$\beta = e2 \, . \, \mathrm{Bar}$$

Le produit β constitue un critère pour assurer un bon rendement quantique de la structure planaire absorbante avec un super-réseau selon l'invention. Le rendement optique augmente lorsque le produit β diminue. Les matériaux qui composent le super réseau SR sont choisis tels que β est inférieure à la valeur limite de 250 nm.meV.

La faible masse effective $m_z$ des porteurs de charges minoritaires selon l'axe du pixel Δ dans la structure planaire d'absorption avec un super-réseau SR tel que décrit assure un meilleur rendement quantique du pixel Pxl détecteur. La masse effective des porteurs de charges positives selon l'axe du pixel dans la structure d'absorption du premier mode de réalisation est multipliée par 50 par rapport à une structure ou il n'y pas inversement entre les niveaux énergétiques des trous lourds et des trous légers.

La grande masse effective $m_{x,y}$ des porteurs de charges minoritaires dans la structure planaire d'absorption dans le plan normal (x,y) réduit le phénomène de diaphonie entre les pixels adjacents. L'asymétrie entre les masses effectives des trous permet de réduire la diaphonie pour des distances entre pixels inférieures à

15μm..

Les différents modes de réalisations de la structure planaire d'absorption SPA sont compatibles avec des architectures globales de pixels permettant de mettre en œuvre l'amélioration du rendement quantique et la réduction de la diaphonie mais aussi la réduction du courant d'obscurité.

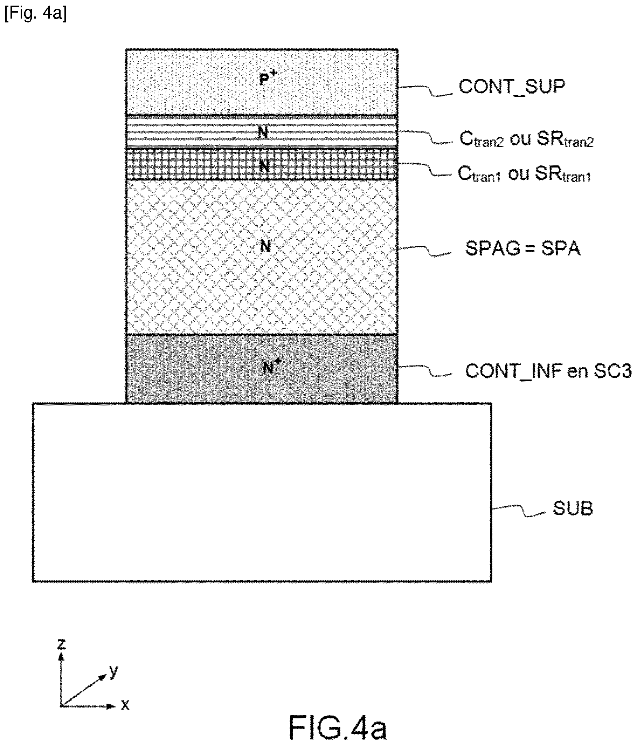

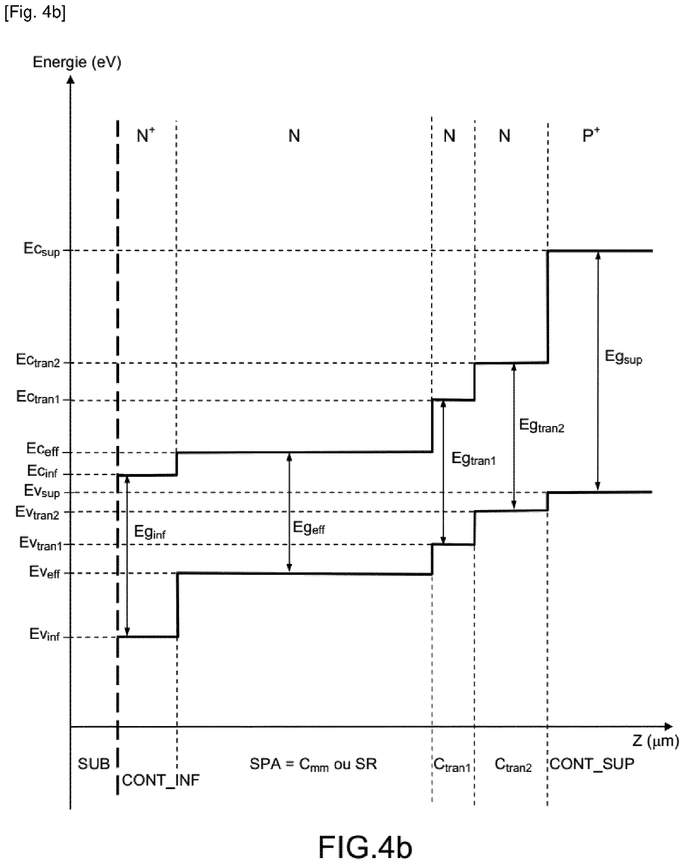

La figure 4a illustre une vue en coupe d'un premier exemple de pixel comportant une structure planaire absorbante selon l'un quelconque des modes de réalisation de l'invention. La figure 4b illustre un schéma de la structure de bandes selon l'axe du pixel de la figure 4a.

Le pixel Pxl comprend le long de la direction d'empilement Z (ou l'axe du pixel) dans cet ordre : le substrat SUB présentant les caractéristiques détaillées précédemment, une structure de contact inférieur CONT_INF en un troisième matériau semi-conducteur SC3 dopé N+, une structure planaire absorbante SPA selon l'invention avec la couche $C_{mm}$ ou les couches C1, C2 dopées N ; une série de deux structures de transition $C_{tran1}$ et $C_{tran2}$ chacune réalisée en un matériau semi-conducteur SC4 ; et une structure de contact supérieur CONT_SUP en un cinquième matériau semi-conducteur SC5 dopé P.

La structure de contact inférieur CONT_INF présente une valeur de maximum de bande de valence de contact inférieur $Ev_{inf}$ strictement inférieure à la valeur de maximum de bande de valence effective $Ev_{eff}$ de la structure planaire absorbante SPA. La structure de contact inférieur CONT_INF présente en outre une valeur de gap d'énergie $Eg_{inf}$ de contact inférieur supérieure ou égale à la première valeur de gap d'énergie effectif $Eg_{eff}$ de la première structure planaire absorbante SPA. A titre d'exemples non limitatifs, il est possible d'utiliser les matériaux suivants pour réaliser le contact inférieur InAsSb dopé N+, GaSb dopé N+, InGaAsSb dopé N+, InAlAsSb dopé N+. Alternativement, il est possible de réaliser le contact inférieur CONT_INF avec un super-réseau SR_INF avec un empilement de couches dopées N+ tel que InAs/InAsSb dopé N+ et InAsSb/InGaAsSb dopé N+.

La première structure de transition $C_{tran1}$ présente une valeur de maximum de bande de valence $Ev_{tran1}$ strictement supérieure à la valeur de maximum de bande de valence effective $Ev_{eff}$ de la première structure planaire absorbante SPA. La première structure de transition $C_{tran1}$ présente en outre une valeur de gap d'énergie de la première structure de transition ($Eg_{tran1}$ strictement supérieure à la première valeur de ga d'énergie effectif $Eg_{eff}$ de la structure planaire absorbante SPA. A titre d'exemples non limitatifs, il est possible d'utiliser les matériaux suivants pour La première structure de transition : InAlAsSb dopé N, InGaAsSb dopé N. Alternativement, il est possible de réaliser La première structure de transition avec un super-réseau $SR_{tran1}$ avec un empilement de couches dopées N tel que $Al_{x1}Ga_{1-x1}As_{y1}Sb_{1-y1}$ / $Al_{x2}Ga_{1-x2}As_{y2}Sb_{1-y2}$.

La seconde structure de transition $C_{tran2}$ présente une valeur de maximum de bande de valence $Ev_{tran1}$ strictement supérieure à celle de la première structure de transition $C_{tran1}$. La seconde structure de transition $C_{tran2}$ présente en outre une valeur de minimum de bande de conduction de $Ec_{tran2}$ strictement supérieure à celle de la première structure de transition $C_{tran1}$. A titre d'exemples non limitatifs, il est possible d'utiliser les matériaux suivants pour la première structure de transition : InAlAsSb dopé N, InGaAsSb dopé N. Alternativement, il est possible de réaliser la première structure de transition avec un super-réseau $SR_{tran2}$ avec un empilement de couches dopées N tel que $Al_{x2}Ga_{1-x2}As_{y2}Sb_{1-y2} / Al_{x3}Ga_{1-x3}As_{y3}Sb_{1-y3}$.

Plus généralement, il est possible de réaliser la série de structures de transition $C_{tran\_i}$ confinée entre la structure de contact supérieur CONT\_SUP et la structure planaire absorbante globale SPAG avec une pluralité de structures de transition $C_{tran\_i}$ de rang i=1 à N en partant de la structure planaire absorbante globale SPAG avec N un entier naturel non nul. Chaque structure de transition $C_{tran\_i}$ de rang i présente une valeur de maximum de bande de valence $Ev_{tran\_i}$ strictement supérieure à celle de la structure de transition précédente $C_{tran\_i-1}$ de rang i-1. Il s'agit alors d'une transition en escalier par rapport aux valeurs de maximum de bande de valence $Ev_{tran\_i}$ tel qu'illustré sur la figure 4b.

Alternativement, il est envisageable de se limiter à une seule structure de transition $C_{tran1}$ entre la structure de contact supérieur CONT\_SUP et la structure planaire absorbante globale SPAG .

La structure de contact supérieur CONT\_SUP présente une valeur de maximum de bande de valence de contact supérieur $Ev_{sup}$ strictement supérieure à la valeur de maximum de bande de valence de chacune des structures de transition $Ev_{tran1}$, $Ev_{tran2}$. Dans un mode de réalisation préférentiel, la structure de contact supérieur CONT\_SUP présente en outre une valeur de gap d'énergie $Eg_{sup}$ de contact supérieur strictement supérieure à la valeur de gap d'énergie de chacune des structures de transition $Eg_{tran1}$, $Eg_{tran2}$.

A titre d'exemples non limitatifs, il est possible d'utiliser les matériaux suivants pour réaliser le contact supérieur GaSb dopé P+, AlGaSb dopé P+, InGaAsSb dopé P+.

L'implémentation de la structure planaire d'absorption Pxl selon l'invention dans le pixel décrit dans la figure 4a est une illustration non limitative. L'invention est compatible avec d'autres variantes d'architectures de pixel permettant aussi de réduire le courant d'obscurité.

Nous soulignons qu'il est possible de réaliser la structure planaire d'absorption globale SPAG du pixel avec une pluralité de structure planaires d'absorption superposées l'une sur l'autre. Ainsi, la structure planaire d'absorption globale SPAG peut contenir une première la structure planaire d'absorption globale SPA selon l'un quelconque des modes de réalisation de l'invention avec une épaisseur de 0,5µm à 5µm. En plus, la structure planaire d'absorption globale SPAG peut contenir une seconde structure planaire d'absorption disposée sur la première la structure planaire d'absorption SPA réalisée en un matériau massif en accord de maille avec le substrat et donc ne présentant pas une levée de dégénérescence. La seconde structure planaire d'absorption a une épaisseur comprise entre 0,5µm et 3µm. Cela permet d'éviter de mettre sous contrainte mécanique l'ensemble de la structure planaire d'absorption globale SPAG.

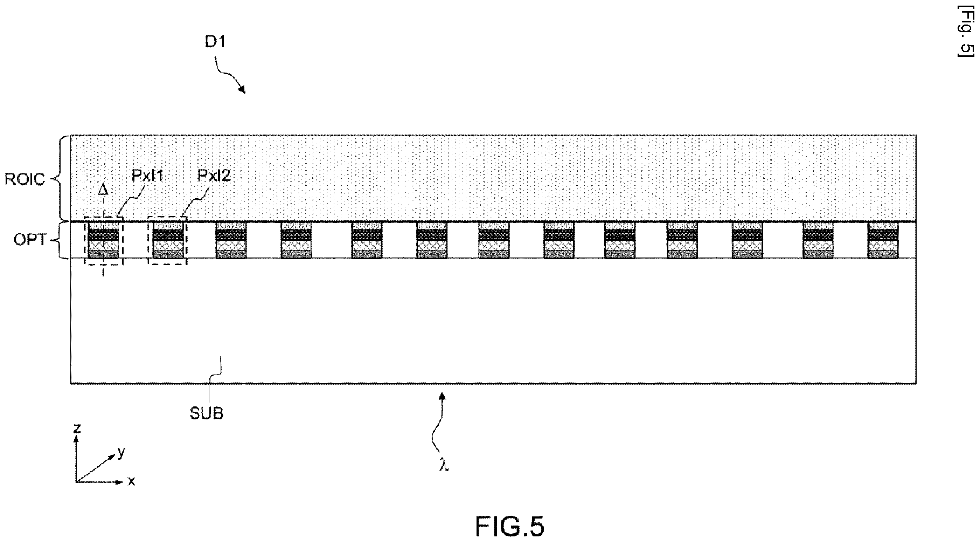

La figure 5 illustre une vue en coupe d'un dispositif D1 de détection de rayonnements infrarouges comprenant une pluralité de pixels Pxl selon l'invention.

Le dispositif un dispositif D1 de détection de rayonnements infrarouges est monté sur le substrat SUB. Il s'agit d'un système hybride optoélectronique, comprenant : une partie optique OPT basée sur une matrice formée par une pluralité de pixels arrangés en lignes et en colonnes et une partie électronique consistant en un circuit de lecture intégré ROIC sur un substrat semi-conducteur permettant de lire individuellement le signal de chaque pixel de la partie optique OPT. Un pixel appartenant au système optoélectronique peut contenir un unique élément photosensible ou une pluralité d'éléments photosensibles connectés entre eux. Alternativement, pour des applications spécifiques, il est envisageable de réaliser la partie optique OPT avec un unique pixel Pxl. Le circuit intégré de lecture ROIC est réalisé au moyen d'une pluralité de transistors et de couches minces en matériau conducteurs, semi-conducteurs ou diélectriques selon la technologie CMOS (Complementary Metal-Oxide-Semiconductor) sur un substrat en silicium. Pour chaque pixel Pxl, une électrode enterrée est associée pour lire les signaux générés par les porteurs de charge photo-générées par la structure photo détectrice d'un pixel Pxl.

**Revendications**

1. Dispositif de détection (D1) de rayonnements infrarouges comprenant au moins un pixel (Pxl) ayant un axe (Δ) selon une direction Z, ledit pixel comprenant une première structure planaire absorbante (SPA) comprenant au moins une couche semi-conductrice ($C_{mm}$, C1, C2);

   chaque couche ($C_{mm}$, C1, C2) de la première structure planaire absorbante (SPA) étant agencée selon une structure cristalline de mailles ; la première structure planaire absorbante (SPA) étant dopée N et étant réalisée par épitaxie sur un substrat (Sub) et la composition des matériaux utilisés pour réaliser l'au moins une couche ($C_{mm}$, C1, C2) de la première structure planaire absorbante (SPA) étant choisie tel que :

   ▪ la première structure planaire absorbante (SPA) présente une bande de valence effective (BV$_{eff}$) formée par une pluralité de niveaux d'énergie (Ev$_{hh}$, Ev$_{lh}$) ; chaque niveau d'énergie (Ev$_{hh}$, Ev$_{ln}$) étant occupé par l'un parmi :

◦ un premier type de porteurs de charges positives dénommé trous lourds (hh) présentant une première masse effective (m$_{hh}$) ;
◦ ou un second type de porteurs de charges positives dénommé trous légers (lh) présentant une seconde masse effective (m$_{lh}$) strictement inférieure à la première masse effective (m$_{hh}$) ;

le niveau d'énergie maximal de la bande de valence effective (BV$_{eff}$) étant occupé par des trous légers (lh) selon l'axe ($\Delta$) du pixel; la structure cristalline de mailles de ladite couche ne présente pas de dislocations résultant d'une relaxation mécanique desdites mailles ; la masse effective des porteurs de charges positives selon l'axe du pixel ($\Delta$) étant inférieure à la moitié de la masse effective des porteurs de charges positives selon des directions définissant un plan orthogonal à l'axe du pixel ($\Delta$).

2. Dispositif de détection (D1) de rayonnements infrarouges selon la revendication 1 dans lequel le substrat (Sub) est arrangé selon une structure cristalline de mailles et dans lequel la composition des matériaux utilisés pour réaliser l'au moins une couche (C$_{mm}$, C1, C2) de la première structure planaire absorbante (SPA) est choisie tel que

▪ les mailles de l'au moins une couche (C$_{mm}$, C1, C2) formant ladite structure planaire absorbante (SPA) subissent des contraintes mécaniques internes pour s'adapter aux mailles de la structure cristalline du substrat (SUB) ;
▪ et tel que la contrainte résultante de la somme des contraintes mécaniques internes est une contrainte de tension.

3. Dispositif de détection (D1) de rayonnements infrarouges selon l'une quelconque des revendications précédentes dans lequel la masse effective des trous porteurs de charges positives selon l'axe du pixel ($\Delta$) est inférieure au dixième de la masse d'un électron libre.

4. Dispositif de détection (D1) de rayonnements infrarouges selon l'une quelconque des revendications précédentes dans lequel la différence entre le niveau d'énergie maximal occupé par des trous légers (Ev$_{lh}$) et le niveau d'énergie maximal occupé par des trous

lourds (Ev$_{hh}$) est supérieure au produit de la constante de Boltzmann par la température de fonctionnement.

5. Dispositif de détection (D1) de rayonnements infrarouges selon l'une quelconque des revendications de 2 à 4 dans lequel la composition des matériaux utilisés pour réaliser l'au moins une couche (C$_{mm}$, C1, C2) de la première structure planaire absorbante (SPA) est choisie tel que l'amplitude la contrainte résultante de la somme des contraintes mécaniques internes est inférieure à une contrainte limite de dislocation prédéterminée ; la densité de dislocations dans la première structure planaire absorbante étant strictement inférieure à 10$^4$ dislocations/cm2

6. Dispositif de détection (D1) de rayonnements infrarouges selon l'une quelconque des revendications précédentes dans lequel la première structure planaire absorbante (SPA) est constituée d'une seule couche (C$_{mm}$) en un matériau massif semi-conducteur de type III-V.

7. Dispositif de détection (D1) de rayonnements infrarouges selon la revendication précédente dans lequel le matériau massif semi-conducteur est l'alliage quaternaire Ga$_{x1}$In$_{1-x1}$As$_{y1}$Sb$_{1-y1}$ avec x1 la fraction molaire de gallium dans l'alliage Ga$_{x1}$In$_{1-x1}$As$_{y1}$Sb$_{1-y1}$ et y1 la fraction molaire d'arsenic dans l'alliage Ga$_x$In$_{1-x1}$As$_{y1}$Sb$_{1-y1}$.

8. Dispositif de détection (D1) de rayonnements infrarouges selon la revendication précédente dans lequel :

▪ le substrat est réalisé en antimoniure de gallium GaSb ;
▪ la fraction molaire x1 de gallium Ga dans l'alliage Ga$_x$In$_{1-x1}$As$_{y1}$Sb$_{1-y1}$ est comprise entre 0 et 1 ;
▪ et la fraction molaire y1 d'arsenic As dans l'alliage Ga$_x$In$_{1-x1}$As$_{y1}$Sb$_{1-y1}$ est comprise entre une valeur minimale (y1$_{min}$) et une valeur maximale (y$^1$ max) tel que :

◦ la valeur minimale (y1$_{min}$) est une fonction affine de la fraction molaire x1 de gallium Ga dans l'alliage Ga$_x$In$_{1-x1}$As$_{y1}$Sb$_{1-y1}$ **caractérisée par** un coefficient directeur égal à -0,92 et une ordonnée à l'origine égale à 0,93
◦ la valeur maximale (y1$_{max}$) de la fraction molaire y1 d'arsenic As dans l'alliage Ga$_x$In$_{1-x1}$As$_{y1}$Sb$_{1-y1}$ est une fonction affine de la fraction molaire x1 de gallium Ga dans l'alliage Ga$_x$In$_{1-x1}$As$_{y1}$Sb$_{1-y1}$ **caractérisée par** un coefficient directeur égal à -0,92 et une ordonnée à l'origine égale à 0,97.

9. Dispositif de détection (D1) de rayonnements infrarouges selon la revendication 7 dans lequel :

- Le substrat est réalisé en antimoniure d'indium InSb ;
- et la fraction molaire x2 de gallium Ga dans le matériau massif semi-conducteur est comprise entre 0,02 et 0,05 ;
- et la fraction molaire y2 d'arsenic As dans le matériau massif semi-conducteur est comprise entre 0,02 et 0,05 .

10. Dispositif de détection (D1) de rayonnements infrarouges selon l'une quelconques des revendications 2 à 5 dans lequel la première structure planaire absorbante (SPA) comprend un premier super-réseau (SR) comprenant un empilement le long de l'axe du pixel ($\Delta$) d'un groupe élémentaire de couches semi-conductrices (G1) comprenant :

- une première couche (C1) en un premier matériau semi-conducteur (SC1) présentant

  ○ une première valeur de minimum de bande de conduction (Ec1) ;
  ○ une première valeur de maximum de bande de valence (Ev1) ;
  ○ une première valeur de gap d'énergie (Eg1) ;

- au moins une deuxième couche (C2) en un deuxième matériau semi-conducteur (SC2) présentant :

  ○ une deuxième valeur de minimum de bande de conduction (Ec2) strictement inférieure à la première valeur de minimum de bande de conduction (Ec1) ;
  ○ une deuxième valeur de maximum de bande de valence (Ev2) strictement inférieure à la première valeur de maximum de bande de valence (Ev1) ;
  ○ et une deuxième valeur de gap d'énergie (Eg2) ;

les mailles de la première couche (C1) subissant des contraintes de tension et les mailles de la deuxième couche (C2) subissant des contraintes de compression.

11. Dispositif de détection (D1) de rayonnements infrarouges selon la revendication précédente dans lequel

le premier super-réseau présente une première valeur de maximum de bande de valence effective ($Ev_{eff}$),
et dans lequel les porteurs de charges positives dans la première couche (C1) d'un groupe élémentaire (G1) voient une barrière d'énergie (BE) égale à la différence entre :

- le niveau d'énergie maximal ($Ev_{hh}$) de la bande de valence effective ($BV_{eff}$) occupé par des trous lourds (hh) ;
- et une première valeur de maximum de bande de valence effective ($Ev_{eff}$) ;

le produit de ladite barrière d'énergie (BE) par l'épaisseur ($e_{m2}$) de la deuxième couche (C2) étant inférieur à une valeur prédéterminée.

12. Dispositif de détection (D1) de rayonnements infrarouges selon l'une quelconque des revendications 10 ou 11 dans lequel le deuxième matériau semiconducteur (SC2) est l'alliage ternaire $InAs_{y3}Sb_{1-y3}$ avec y3 la fraction molaire d'arsenic dans l'alliage $InAs_{y3}Sb_{1-y3}$

13. Dispositif de détection (D1) de rayonnements infrarouges selon la revendication 12 dans lequel le premier matériau semi-conducteur (SC1) est l'alliage quaternaire $Ga_{x3}In_{1-x3}As_{y4}Sb_{1-y4}$
avec x3 la fraction molaire de gallium dans l'alliage $Ga_{x3}In_{1-x3}As_{y4}Sb_{1-y4}$ et y4 la fraction molaire d'arsenic dans l'alliage $Ga_{x3}In_{1-x2}As_{y4}Sb_{1-y4}$.

14. Dispositif de détection (D1) de rayonnements infrarouges selon la revendication 13 dans lequel :

- la fraction molaire y3 d'arsenic dans l'alliage $InAs_{y3}Sb_{1-y3}$ est comprise entre 0,6 et 0,88.
- la fraction molaire x3 de gallium dans l'alliage $Ga_{x3}In_{1-x3}As_{y4}Sb_{1-y4}$ est comprise entre 0,2 et 0,5
- et la fraction molaire y4 d'arsenic dans l'alliage $Ga_{x3}In_{1-x3}As_{y4}Sb_{1-y4}$ est comprise entre une valeur minimale ($y4_{min}$) et une valeur maximale ($y4_{max}$) tel que :

  ○ la valeur minimale ($y4_{min}$) de la fraction molaire y4 d'arsenic dans l'alliage $Ga_{x3}In_{1-x3}As_{y4}Sb_{1-y4}$ étant une fonction affine de la fraction molaire x3 de gallium dans l'alliage $Ga_{x3}In_{1-x3}As_{y4}Sb_{1-y4}$ **caractérisée par** un coefficient directeur égal à -0,92 et une ordonnée à l'origine égale à 0,93.
  ○ la valeur maximale ($y4_{max}$) de la fraction molaire y4 d'arsenic dans l'alliage $Ga_{x3}In_{1-x3}As_{y4}Sb_{1-y4}$ étant une fonction affine de la fraction molaire x3 de gallium dans l'alliage $Ga_{x3}In_{1-x3}As_{y4}Sb_{1-y4}$ **caractérisée par** un coefficient directeur égal à -0,66 et une ordonnée à l'origine égale à 1,13.

**15.** Dispositif de détection (D1) selon l'une quelconque des revendications de 1 à 14 dans lequel la première structure planaire absorbante (SPA) présente une première valeur de maximum de bande de valence effective ($Ev_{eff}$), une première valeur de minimum de bande de conduction effective ($Ec_{eff}$) et une première valeur de gap d'énergie effectif ($Eg_{eff}$); le pixel comprend le long de son axe (Δ) dans cet ordre :

- le substrat (SUB) ;
- Une structure de contact inférieur (CONT_INF) en un troisième matériau semi-conducteur (SC3) ou en un super-réseau de contact inférieur ($SR_{inf}$), dopée N+ et présentant :

  ○ une valeur de maximum de bande de valence de contact inférieur ($Ev_{inf}$) strictement inférieure à la valeur de maximum de bande de valence effective ($Ev_{eff}$) de la première structure planaire absorbante (SPA);
  ○ et une valeur de gap d'énergie ($Eg_{inf}$) de contact inférieur supérieure ou égale à la première valeur de gap d'énergie effectif ($Eg_{eff}$) de la première structure planaire absorbante (SPA) ;

- Une structure planaire absorbante globale (SPAG) comprenant :
  la première structure planaire absorbante (SPA); les couches (C1, C2, $C_{mm}$) de ladite première structure planaire absorbante (SPA) étant dopées N ;
- une ou plusieurs structures de transition ($C_{tran1}$, $C_{tran2}$, $C_{tran\_i}$) ; la structure de transition ($C_{tran1}$) en contact avec la structure planaire absorbante globale (SPAG) étant dénommée structure de transition initiale ; la structure de transition initiale étant réalisée en un quatrième matériau semi-conducteur (SC4) ou en un premier super-réseau de la structure de transition ($SR_{tran1}$), dopée N et présentant :

  ○ une valeur de maximum de bande de valence de la structure de transition initiale ($Ev_{tran1}$) strictement supérieure à la valeur de maximum de bande de valence effective ($Ev_{eff}$) de la première structure planaire absorbante (SPA);
  ○ et une valeur de gap d'énergie de la structure de transition initiale ($Eg_{tran1}$) strictement supérieure à la première valeur de gap d'énergie effectif ($Eg_{eff}$) de la première structure planaire absorbante (SPA) ;

- Une structure de contact supérieur (CONT_SUP) en un cinquième matériau semi-conducteur (SC5) ou en un super-réseau de contact supérieur ($SR_{sup}$), dopée P+ et présentant :

  ○ une valeur de maximum de bande de valence de contact supérieur ($Ev_{sup}$) strictement supérieure à la valeur de maximum de bande de valence de chaque structure de transition ($Ev_{tran1}$, $EV_{tran1}$) ;
  ○ et une valeur de gap d'énergie ($Eg_{sup}$) de contact supérieur strictement supérieure à la valeur de gap d'énergie de chaque structure de transition ($Eg_{tran1}$, $Eg_{tran1}$) .

**16.** Dispositif de détection (D1) selon la revendication précédente dans lequel le pixel comprend plusieurs structures de transition ($C_{tran1}$, $C_{tran2}$, $C_{tran\_i}$) de rang i=1 à N croissant en partant de la structure planaire absorbante globale (SPAG) vers structure de contact supérieur (CONT_SUP), avec N un entier naturel non nul, tel que :

- chaque structure de transition ($C_{tran2}$ $C_{tran\_i}$) de rang i=2 à N présente une valeur de maximum de bande de valence ($Ev_{tran2}$) strictement supérieure à la valeur de maximum de bande de valence de la structure de transition ($Ev_{tran1}$) de rang i-1 .

**Patentansprüche**

**1.** Vorrichtung (D1) zum Erkennen von Infrarotstrahlen, umfassend mindestens ein Pixel (PxI) mit einer Achse (Δ) entlang einer Richtung Z, wobei das Pixel eine erste absorbierende planare Struktur (SPA) umfasst, die mindestens eine Halbleiterschicht ($C_{mm}$, C1, C2) umfasst;

wobei jede Schicht ($C_{mm}$, C1, C2) der ersten absorbierenden planaren Struktur (SPA) entlang einer Kristallgitterstruktur angeordnet ist; wobei die erste absorbierende planare Struktur (SPA) N-dotiert ist und durch Epitaxie auf einem Substrat (Sub) hergestellt ist und die Zusammensetzung der Werkstoffe, die zum Herstellen der mindestens einen Schicht ($C_{mm}$, C1, C2) der ersten absorbierenden planaren Struktur (SPA) verwendet werden, derart ausgewählt ist, dass:

- die erste absorbierende planare Struktur (SPA) ein effektives Valenzband ($BV_{eff}$) aufweist, das durch eine Vielzahl von Energieniveaus ($Ev_{hh}$, $Ev_{lh}$) gebildet ist; wobei jedes Energieniveau ($Ev_{hh}$, $Ev_{lh}$) von einer der Folgenden besetzt ist:

  ○ einer ersten Art von positiven Ladungsträgern, die als schwere Löcher (hh) bezeichnet wird, die eine erste effektive Masse ($m_{hh}$) aufweist;

◦ oder einer zweiten Art von positiven Ladungsträgern, die als leichte Löcher (lh) bezeichnet wird, die eine zweite effektive Masse ($m_{lh}$) aufweist, die streng geringer als die erste effektive Masse ($m_{hh}$) ist;

wobei das maximale Energieniveau des effektiven Valenzbandes ($BV_{eff}$) durch leichte Löcher (lh) entlang der Achse ($\Delta$) des Pixels belegt ist; die Kristallgitterstruktur der Schicht keine Verschiebungen aufweist, die aus einer mechanischen Entspannung der Gitter resultieren; wobei die effektive Masse der positiven Ladungsträger entlang der Achse des Pixels ($\Delta$) kleiner als die Hälfte der effektiven Masse der positiven Ladungsträger entlang Richtungen ist, die eine Ebene orthogonal zur Achse des Pixels ($\Delta$) definieren.

**2.** Vorrichtung (D1) zum Erkennen von Infrarotstrahlen nach Anspruch 1, wobei das Substrat (Sub) entlang einer Kristallgitterstruktur angeordnet ist und wobei die Zusammensetzung der Werkstoffe, die zum Herstellen der mindestens einen Schicht ($C_{mm}$, C1, C2) der ersten absorbierenden planaren Struktur (SPA) verwendet werden, derart ausgewählt ist, dass:

▪ die Gitter der mindestens einen Schicht ($C_{mm}$, C1, C2), die die absorbierende planare Struktur (SPA) bildet, internen mechanischen Belastungen unterzogen werden, um sich an die Gitter der Kristallstruktur des Substrats (SUB) anzupassen;
▪ und derart, dass die aus der Summe der internen mechanischen Belastungen resultierende Belastung eine Zugbelastung ist.

**3.** Vorrichtung (D1) zum Erkennen von Infrarotstrahlen nach einem der vorhergehenden Ansprüche, wobei die effektive Masse der Löcher, die positive Ladungen tragen, entlang der Achse des Pixels ($\Delta$) kleiner als ein Zehntel der Masse eines freien Elektrons ist.

**4.** Vorrichtung (D1) zum Erkennen von Infrarotstrahlen nach einem der vorhergehenden Ansprüche, wobei die Differenz zwischen dem maximalen Energieniveau, das von leichten Löchern ($Ev_{lh}$) besetzt ist, und dem maximalen Energieniveau, das von schweren Löchern ($Ev_{hh}$) besetzt ist, größer als das Produkt aus der Boltzmann-Konstante und der Betriebstemperatur ist.

**5.** Vorrichtung (D1) zum Erkennen von Infrarotstrahlen nach einem der Ansprüche 2 bis 4, wobei die Zusammensetzung der Werkstoffe, die verwendet werden, um die mindestens eine Schicht ($C_{mm}$, C1, C2) der ersten absorbierenden planaren Struktur (SPA) herzustellen, derart ausgewählt ist, dass die Amplitude der Belastung, die aus der Summe der internen mechanischen Belastungen resultiert, kleiner als eine vorbestimmte Verschiebungsgrenzbelastung ist;

die Dichte von Verschiebungen in der ersten absorbierenden planaren Struktur streng kleiner als $10^4$ Verschiebungen/cm2 ist.

**6.** Vorrichtung (D1) zum Erkennen von Infrarotstrahlen nach einem der vorhergehenden Ansprüche, wobei die erste absorbierende planare Struktur (SPA) aus einer einzigen Schicht ($C_{mm}$) aus einem Halbleiter-Bulk-Material vom Typ III-V besteht.

**7.** Vorrichtung (D1) zum Erkennen von Infrarotstrahlen nach dem vorhergehenden Anspruch, wobei das Halbleiter-Bulk-Material die quaternäre Legierung $Ga_{x1}In_{1-x1}As_{y1}Sb_{1-y1}$ ist, wobei x1 der Stoffmengenanteil von Gallium in der Legierung $Ga_{x1}In_{1-x1}As_{y1}Sb_{1-y1}$ ist und y1 der Stoffmengenanteil von Arsen in der Legierung $Ga_xIn_{1-x1}As_{y1}Sb_{1-y1}$ ist.

**8.** Vorrichtung (D1) zum Erkennen von Infrarotstrahlen nach dem vorhergehenden Anspruch, wobei:

▪ das Substrat aus Galliumantimonid GaSb hergestellt ist;
▪ der Stoffmengenanteil x1 von Gallium Ga in der Legierung $Ga_xIn_{1-x1}As_{y1}Sb_{1-y1}$ zwischen 0 und 1 liegt;
▪ und der Stoffmengenanteil y1 von Arsen As in der Legierung $Ga_xIn_{1-x1}As_{y1}Sb_{1-y1}$ zwischen einem Mindestwert ($y1_{min}$) und einem Höchstwert ($y1_{max}$) liegt, sodass

◦ der Mindestwert ($y1_{min}$) eine affine Funktion des Stoffmengenanteils x1 von Gallium Ga in der Legierung $Ga_xIn_{1-x1}As_{y1}Sb_{1-y1}$ ist, die durch einen Leitkoeffizienten gleich -0,92 und eine Ordinate am Nullpunkt gleich 0,93 gekennzeichnet ist,
◦ der Höchstwert ($y1_{max}$) des Stoffmengenanteils y1 von Arsen As in der Legierung $Ga_xIn_{1-x1}As_{y1}Sb_{1-y1}$ eine affine Funktion des Stoffmengenanteils x1 von Gallium Ga in der Legierung $Ga_xIn_{1-x1}As_{y1}Sb_{1-y1}$ ist, die durch einen Leitkoeffizienten gleich -0,92 und eine Ordinate am Nullpunkt gleich 0,97 gekennzeichnet ist.

**9.** Vorrichtung (D1) zum Erkennen von Infrarotstrahlen nach Anspruch 7, wobei:

- das Substrat aus Indiumantimonid InSb hergestellt ist;
- und der Stoffmengenanteil x2 von Gallium Ga in dem Halbleiter-Bulk-Material zwischen 0,02 und 0,05 liegt;
- und der Stoffmengenanteil y2 von Arsen As in dem Halbleiter-Bulk-Material zwischen 0,02 und 0,05 liegt.

10. Vorrichtung (D1) zum Erkennen von Infrarotstrahlen nach einem der Ansprüche 2 bis 5, wobei die erste absorbierende planare Struktur (SPA) ein erstes Übergitter (SR) umfasst, welches einen Stapel entlang der Achse des Pixels ($\Delta$) einer Elementargruppe von Halbleiterschichten (G1) umfasst, Folgendes umfassend:

  - eine erste Schicht (C1) aus einem ersten Halbleiterwerkstoff (SC1), aufweisend

    o einen ersten Mindestwert für ein Leitungsband (Ec1);
    o einen ersten Höchstwert für ein Valenzband (Ev1);
    o einen ersten Wert für eine Energielücke (Eg1);

  - mindestens eine zweite Schicht (C2) aus einem zweiten Halbleiterwerkstoff (SC2), aufweisend:

    o einen zweiten Mindestwert für das Leitungsband (Ec2), der streng kleiner als der erste Mindestwert für das Leitungsband (Ec1) ist;
    o einen zweiten Höchstwert für das Valenzband (Ev2), der streng kleiner als der erste Höchstwert für das Valenzband (Ev1) ist;
    o und einen zweiten Wert für die Energielücke (Eg2);

  wobei die Gitter der ersten Schicht (C1) Zugbelastungen unterzogen werden und die Gitter der zweiten Schicht (C2) Druckbelastungen unterzogen werden.

11. Vorrichtung (D1) zum Erkennen von Infrarotstrahlen nach dem vorhergehenden Anspruch, wobei

  das erste Übergitter einen ersten Höchstwert für das effektive Valenzband ($Ev_{eff}$) aufweist, und wobei die positiven Ladungsträger in der ersten Schicht (C1) einer Elementargruppe (G1) eine Energiebarriere (BE) gleich der Differenz zwischen Folgenden erfahren:

  - dem maximalen Energieniveau ($Ev_{hh}$) des effektiven Valenzbandes ($BV_{eff}$), das von schweren Löchern (hh) besetzt ist;
- und einem ersten Höchstwert für das effektive Valenzband ($Ev_{eff}$);

wobei das Produkt aus der Energiebarriere (BE) und der Dicke ($e_{m2}$) der zweiten Schicht (C2) kleiner als ein vorbestimmter Wert ist.

12. Vorrichtung (D1) zum Erkennen von Infrarotstrahlen nach einem der Ansprüche 10 oder 11, wobei der zweite Halbleiterwerkstoff (SC2) die ternäre Legierung $InAs_{y3}Sb_{1-y3}$ ist, wobei y3 der Stoffmengenanteil von Arsen in der Legierung $InAs_{y3}Sb_{1-y3}$ ist.

13. Vorrichtung (D1) zum Erkennen von Infrarotstrahlen nach Anspruch 12, wobei der erste Halbleiterwerkstoff (SC1) die quatenäre Legierung $Ga_{x3}In_{1-x3}As_{y4}Sb_{1-y4}$ ist, wobei x3 der Stoffmengenanteil von Gallium in der Legierung $Ga_{x3}In_{1-x3}As_{y4}Sb_{1-y4}$ ist und y4 der Stoffmengenanteil von Arsen in der Legierung $Ga_{x3}In_{1-x2}As_{y4}Sb_{1-y4}$ ist.

14. Vorrichtung (D1) zum Erkennen von Infrarotstrahlen nach Anspruch 13, wobei:

  - der Stoffmengenanteil y3 von Arsen in der Legierung $InAs_{y3}Sb_{1-y3}$ zwischen 0,6 und 0,88 liegt;
  - der Stoffmengenanteil x3 von Gallium in der Legierung $Ga_{x3}In_{1-x3}As_{y4}Sb_{1-y4}$ zwischen 0,2 und 0,5 liegt,
  - und der Stoffmengenanteil y4 von Arsen in der Legierung $Ga_{x3}In_{1-x3}A_{Sy4}Sb_{1-y4}$ zwischen einem Mindestwert ($y4_{min}$) und einem Höchstwert ($y4_{max}$) liegt, sodass:

    ∘ der Mindestwert ($y4_{min}$) des Stoffmengenanteils y4 von Arsen in der Legierung $Ga_{x3}In_{1-x3}As_{y4}Sb_{1-y4}$ eine affine Funktion des Stoffmengenanteils x3 von Gallium in der Legierung $Ga_{x3}In_{1-x3}As_{y4}Sb_{1-y4}$ ist, die durch einen Leitkoeffizienten gleich -0,92 und eine Ordinate am Nullpunkt gleich 0,93 gekennzeichnet ist,
    ∘ der Höchstwert ($y4_{max}$) des Stoffmengenanteils y4 von Arsen in der Legierung $Ga_{x3}In_{1-x3}As_{y4}Sb_{1-y4}$ eine affine Funktion des Stoffmengenanteils x3 von Gallium in der Legierung $Ga_{x3}In_{1-x3}As_{y4}Sb_{1-y4}$ ist, die durch einen Leitkoeffizienten gleich -0,66 und eine Ordinate am Nullpunkt gleich 1,13 gekennzeichnet ist.

15. Erkennungsvorrichtung (D1) nach einem der Ansprüche 1 bis 14, wobei die erste absorbierende planare Struktur (SPA) einen ersten Höchstwert für das effektive Valenzband (Ev$_{eff}$), einen ersten Mindestwert für das effektive Leitungsband (Ec$_{eff}$) und einen ersten Wert für die effektive Energielücke (Eg$_{eff}$) aufweist; das Pixel entlang seiner Achse ($\Delta$) in der angegebenen Reihenfolge Folgendes umfasst:

- das Substrat (SUB);
- eine untere Kontaktstruktur (CONT_INF) aus einem dritten Halbleiterwerkstoff (SC3) oder aus einem unteren Kontaktübergitter (SR$_{inf}$), die N+-dotiert ist und Folgendes aufweist:

  o einen Höchstwert für das Valenzband des unteren Kontakts (Ev$_{inf}$), der streng kleiner als der Höchstwert für das effektive Valenzband (Ev$_{eff}$) der ersten absorbierenden planaren Struktur (SPA) ist;
  o und einen Wert für die Energielücke (Eg$_{inf}$) des unteren Kontakts, der größer als der oder gleich dem ersten Wert für die effektive Energielücke (Eg$_{eff}$) der ersten absorbierenden planaren Struktur (SPA) ist;

- eine globale absorbierende planare Struktur (SPAG), Folgendes umfassend:
  die erste absorbierende planare Struktur (SPA);die Schichten (C1, C2, C$_{mm}$) der ersten absorbierenden planaren Struktur (SPA), die N-dotiert sind;
- eine oder mehrere Übergangsstrukturen (C$_{tran1}$, C$_{tran2}$, C$_{tran-i}$); wobei die Übergangsstruktur (C$_{tran1}$) in Kontakt mit der globalen absorbierenden planaren Struktur (SPAG) als Anfangsübergangsstruktur bezeichnet wird; wobei die Anfangsübergangsstruktur aus einem vierten Halbleiterwerkstoff (SC4) oder aus einem ersten Übergitter der Übergangsstruktur (SR$_{tran1}$), die N-dotiert ist, hergestellt ist und Folgendes aufweist:

  o einen Höchstwert für das Valenzband der Anfangsübergangsstruktur (Ev$_{tran1}$), der streng größer als der Höchstwert für das effektive Valenzband (Ev$_{eff}$) der ersten absorbierenden planaren Struktur (SPA) ist;
  o und einen Wert für eine Energielücke der Anfangsübergangsstruktur (Eg$_{tran1}$), der streng größer als der erste Wert für die effektive Energielücke (Eg$_{eff}$) der ersten absorbierenden planaren Struktur (SPA) ist;

- eine obere Kontaktstruktur (CONT_SUP) aus einem fünften Halbleiterwerkstoff (SC5) oder aus einem oberen Kontaktübergitter (SR$_{sup}$), die P+-dotiert ist und Folgendes aufweist:

  o einen Höchstwert für das Valenzband des oberen Kontakts (Ev$_{sup}$), der streng größer als der Höchstwert für das Valenzband jeder Übergangsstruktur (Ev$_{tran1}$, EV$_{tran1}$) ist;
  o und einen Wert für die Energielücke (Eg$_{sup}$) des oberen Kontakts, der streng größer als der Wert für die Energielücke jeder Übergangsstruktur (Eg$_{tran1}$, Eg$_{tran1}$) ist.

16. Erkennungsvorrichtung (D1) nach dem vorhergehenden Anspruch, wobei das Pixel mehrere Übergangsstrukturen (C$_{tran1}$, C$_{tran2}$, C$_{tran-i}$) vom Rang i=1 bis N umfasst, die ausgehend von der globalen absorbierenden planaren Struktur (SPAG) zur oberen Kontaktstruktur (CONT_SUP) zunehmen, wobei N eine natürliche ganze Zahl ungleich Null ist, sodass:

- jede Übergangsstruktur (C$_{tran2}$, C$_{tran-i}$) vom Rang i=2 bis N einen Höchstwert für das Valenzband (Ev$_{tran2}$) aufweist, der streng größer als der Höchstwert für das Valenzband der Übergangsstruktur (Ev$_{tran1}$) vom Rang i=1 ist.

**Claims**

1. A detection device (D1) for detecting infrared radiation, comprising at least one pixel (Pxl) having an axis ($\Delta$) in a direction Z, said pixel comprising a first absorbent planar structure (SPA) comprising at least one semiconductor layer (C$_{mm}$, C1, C2);

   each layer (C$_{mm}$, C1, C2) of the first absorbent planar structure (SPA) being arranged in a crystal lattice structure;
   the first absorbent planar structure (SPA) being N-doped and being produced epitaxially on a substrate (Sub), and the composition of the materials used to produce the at least one layer (C$_{mm}$, C1, C2) of the first absorbent planar structure (SPA) being chosen such that:

   - the first absorbent planar structure (SPA) has an effective valence band (BV$_{eff}$) formed by a plurality of energy levels (Ev$_{hh}$, Ev$_{lh}$); each energy level (Ev$_{hh}$, Ev$_{lh}$) being occupied by one of:

     o a first type of positive charge carriers, called heavy holes (hh), having a first effective mass (m$_{hh}$);
     o or a second type of positive charge carriers, called light holes (lh), having a second effective mass (m$_{lh}$) strictly less than the first effective mass (m$_{hh}$);

   the maximum energy level of the effective valence band ($BV_{eff}$) being occupied by light holes (lh) along the axis ($\Delta$) of the pixel;
the crystal lattice structure of said layer does not exhibit any dislocations resulting from mechanical relaxation of said lattices;
the effective mass of the positive charge carriers along the axis of the pixel ($\Delta$) being less than half the effective mass of the positive charge carriers in directions defining a plane orthogonal to the axis of the pixel ($\Delta$).

2. The detection device (D1) for detecting infrared radiation according to claim 1, wherein the substrate (Sub) is arranged in a crystal lattice structure and wherein the composition of the materials used to produce the at least one layer ($C_{mm}$, C1, C2) of the first absorbent planar structure (SPA) is chosen such that

   - the lattices of the at least one layer ($C_{mm}$, C1, C2) forming said absorbent planar structure (SPA) experience internal mechanical stresses so as to adapt to the lattices of the crystal structure of the substrate (SUB);
   - and such that the stress resulting from the sum of the internal mechanical stresses is a tensile stress.

3. The detection device (D1) for detecting infrared radiation according to any one of the preceding claims, wherein the effective mass of the holes carrying positive charges along the axis of the pixel ($\Delta$) is less than one tenth of the mass of a free electron.

4. The detection device (D1) for detecting infrared radiation according to any one of the preceding claims, wherein the difference between the maximum energy level occupied by light holes ($Ev_{lh}$) and the maximum energy level occupied by heavy holes ($Ev_{hh}$) is greater than the product of the Boltzmann constant and the operating temperature.

5. The detection device (D1) for detecting infrared radiation according to any one of claims 2 to 4, wherein the composition of the materials used to produce the at least one layer ($C_{mm}$, C1, C2) of the first absorbent planar structure (SPA) is chosen such that the amplitude of the stress resulting from the sum of the internal mechanical stresses is less than a predetermined dislocation limit stress;
the density of dislocations in the first absorbent planar structure being strictly less than $10^4$ dislocations/cm2.

6. The detection device (D1) for detecting infrared radiation according to any one of the preceding claims, wherein the first absorbent planar structure (SPA) consists of a single layer ($C_{mm}$) made of a bulk III-V-type semiconductor material.

7. The detection device (D1) for detecting infrared radiation according to the preceding claim, wherein the bulk semiconductor material is the quaternary alloy $Ga_{x1}In_{1-x1}As_{y1}Sb_{1-y1}$,
where x1 is the molar fraction of gallium in the alloy $Ga_{x1}In_{1-x1}As_{y1}Sb_{1-y1}$ and y1 is the molar fraction of arsenic in the alloy $Ga_xIn_{1-x1}As_{y1}Sb_{1-y1}$,

8. The detection device (D1) for detecting infrared radiation according to the preceding claim, wherein:

   - the substrate is made of gallium antimonide GaSb;
   - the molar fraction x1 of gallium Ga in the alloy $Ga_xIn_{1-x1}As_{y1}Sb_{1-y1}$ is between 0 and 1;
   - and the molar fraction y1 of arsenic As in the alloy $Ga_xIn_{1-x1}As_{y1}Sb_{1-y1}$ is between a minimum value ($y1_{min}$) and a maximum value ($y1_{max}$) such that:

     ○ the minimum value ($y1_{min}$) is an affine function of the molar fraction x1 of gallium Ga in the alloy $Ga_xIn_{1-x1}As_{y1}Sb_{1-y1}$ **characterised by** a leading coefficient equal to -0.92 and an ordinate at the origin equal to 0.93,
     ○ the maximum value ($y1_{max}$) of the molar fraction y1 of arsenic As in the alloy $Ga_xIn_{1-x1}As_{y1}Sb_{1-y1}$ is an affine function of the molar fraction x1 of gallium Ga in the alloy $Ga_xIn_{1-x1}As_{y1}Sb_{1-y1}$ **characterised by** a leading coefficient equal to -0.92 and an ordinate at the origin equal to 0.97.

9. The detection device (D1) for detecting infrared radiation according to claim 7, wherein:

   - the substrate is made of indium antimonide InSb;
   - and the molar fraction x2 of gallium Ga in the bulk semiconductor material is between 0.02 and 0.05;
   - and the molar fraction y2 of arsenic As in the bulk semiconductor material is between 0.02 and 0.05.

10. The detection device (D1) for detecting infrared radiation according to any one of claims 2 to 5, wherein the first absorbent planar structure (SPA) comprises a first superlattice (SR) comprising a stack along the axis of the pixel ($\Delta$) of an elementary group of semiconductor layers (G1) comprising:

    - a first layer (C1) made of a first semiconductor material (SC1) having

○ a first conduction band minimum value (Ec1);
○ a first valence band maximum value (Ev1);
○ a first energy gap value (Eg1);

■ at least one second layer (C2) made of a second semiconductor material (SC2) having:

○ a second conduction band minimum value (Ec2) strictly less than the first conduction band minimum value (Ec1);
○ a second valence band maximum value (Ev2) strictly less than the first valence band maximum value (Ev1);
○ and a second energy gap value (Eg2);

the lattices of the first layer (C1) experiencing tensile stresses and the lattices of the second layer (C2) experiencing compressive stresses.

11. The detection device (D1) for detecting infrared radiation according to the preceding claim, wherein

the first superlattice has a first effective valence band maximum value ($Ev_{eff}$),
and wherein the positive charge carriers in the first layer (C1) of an elementary group (G1) see an energy barrier (BE) equal to the difference between:

■ the maximum energy level ($Ev_{hh}$) of the effective valence band ($BV_{eff}$) occupied by heavy holes (hh);
■ and a first effective valence band maximum value ($Ev_{eff}$);

the product of said energy barrier (BE) and the thickness ($e_{m2}$) of the second layer (C2) being less than a predetermined value.

12. The detection device (D1) for detecting infrared radiation according to one of claims 10 or 11, wherein the second semiconductor material (SC2) is the ternary alloy $InAs_{y3}Sb_{1-y3}$,
where y3 is the molar fraction of arsenic in the alloy $InAs_{y3}Sb_{1-y3}$.

13. The detection device (D1) for detecting infrared radiation according to claim 12, wherein the first semiconductor material (SC1) is the quaternary alloy $Ga_{x3}In_{1-x3}As_{y4}Sb_{1-y4}$,
where x3 is the molar fraction of gallium in the alloy $Ga_{x3}In_{1-x3}As_{y4}Sb_{1-y4}$ and y4 is the molar fraction of arsenic in the alloy $Ga_{x3}In_{1-x2}As_{y4}Sb_{1-y4}$.

14. The detection device (D1) for detecting infrared radiation according to claim 13, wherein:

■ the molar fraction y3 of arsenic in the alloy $InAs_{y3}Sb_{1-y3}$ is between 0.6 and 0.88,
■ the molar fraction x3 of gallium in the alloy $Ga_{x3}In_{1-x3}As_{y4}Sb_{1-y4}$ is between 0.2 and 0.5,
■ and the molar fraction y4 of arsenic in the alloy $Ga_{x3}In_{1-x3}As_{y4}Sb_{1-y4}$ is between a minimum value ($y4_{min}$) and a maximum value ($y4_{max}$) such that:

○ the minimum value ($y4_{min}$) of the molar fraction y4 of arsenic in the alloy $Ga_{x3}In_{1-x3}As_{y4}Sb_{1-y4}$ being an affine function of the molar fraction x3 of gallium in the alloy $Ga_{x3}In_{1-x3}As_{y4}Sb_{1-y4}$ **characterised by** a leading coefficient equal to -0.92 and an ordinate at the origin equal to 0.93,
○ the maximum value ($y4_{max}$) of the molar fraction y4 of arsenic in the alloy $Ga_{x3}In_{1-x3}As_{y4}Sb_{1-y4}$ being an affine function of the molar fraction x3 of gallium in the alloy $Ga_{x3}In_{1-x3}As_{y4}Sb_{1-y4}$ **characterised by** a leading coefficient equal to -0.66 and an ordinate at the origin equal to 1.13.

15. The detection device (D1) according to any one of claims 1 to 14, wherein the first absorbent planar structure (SPA) has a first effective valence band maximum value ($Ev_{eff}$), a first effective conduction band minimum value ($Ec_{eff}$) and a first effective energy gap value ($Eg_{eff}$); the pixel comprises, along its axis (Δ) and in this order:

■ the substrate (SUB);
■ a lower contact structure (CONT_INF) made of a third semiconductor material (SC3) or of a lower contact superlattice ($SR_{inf}$), the structure being N+-doped and having:

○ a lower contact valence band maximum value ($Ev_{inf}$) strictly less than the effective valence band maximum value ($Ev_{eff}$) of the first absorbent planar structure (SPA);
○ and a lower contact energy gap value ($Eg_{inf}$) higher than or equal to the first effective energy gap value ($Eg_{eff}$) of the first absorbent planar structure (SPA);

■ an overall absorbent planar structure (SPAG) comprising:
the first absorbent planar structure (SPA); the layers (C1, C2, $C_{mm}$) of said first absorbent planar structure (SPA) being N-doped;
■ one or more transition structures ($C_{tran1}$, $C_{tran2}$, $C_{tran\_i}$); the transition structure ($C_{tran1}$) in contact with the overall absorbent planar structure (SPAG) being called initial transition structure; the initial transition structure being made of a fourth semiconductor material (SC4) or of a first superlattice of the transition structure ($SR_{tran1}$), the structure being N-doped and having:

　　○ a valence band maximum value of the initial transition structure ($Ev_{tran1}$) strictly greater than the effective valence band maximum value ($Ev_{eff}$) of the first absorbent planar structure (SPA);
　　○ and an energy gap value of the initial transition structure ($Eg_{tran1}$) strictly greater than the first effective energy gap value ($Eg_{eff}$) of the first absorbent planar structure (SPA);

　■ an upper contact structure (CONT_SUP) made of a fifth semiconductor material (SC5) or of an upper contact superlattice ($SR_{sup}$), the structure being P+-doped and having:

　　○ an upper contact valence band maximum value ($Ev_{sup}$) strictly greater than the valence band maximum value of each transition structure ($Ev_{tran1}$, $Ev_{tran1}$);
　　○ and an upper contact energy gap value ($Eg_{sup}$) strictly greater than the energy gap value of each transition structure ($Eg_{tran1}$, $Eg_{tran1}$),

16. The detection device (D1) according to the preceding claim, wherein the pixel comprises multiple transition structures ($C_{tran1}$, $C_{tran2}$, $C_{tran\_i}$) of rank i=1 to N increasing from the overall absorbent planar structure (SPAG) to the upper contact structure (CONT_SUP), where N is a non-zero natural integer, such that:

　■ each transition structure ($C_{tran2}$, $C_{tran\_i}$) of rank i=2 to N has a valence band maximum value ($Ev_{tran2}$) strictly greater than the valence band maximum value of the transition structure ($Ev_{tran1}$) of rank i-1.

[Fig. 1a]

FIG.1a

[Fig. 1b]

FIG.1b

[Fig. 2a]

FIG.2a

[Fig. 2b]

FIG.2b

[Fig. 2c]

FIG.2c

[Fig. 2d]

FIG 2d

[Fig. 3a]

FIG.3a

[Fig. 3b]

FIG.3b

[Fig. 3c]

FIG.3c

[Fig. 3d]

FIG.3d

[Fig. 4a]

CONT_SUP

$C_{tran2}$ ou $SR_{tran2}$

$C_{tran1}$ ou $SR_{tran1}$

SPAG = SPA

CONT_INF en SC3

SUB

FIG.4a

[Fig. 4b]

FIG.4b

[Fig. 5]

EP 4 289 008 B1

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3482421 B1
- EP 1642345 B1

- JP H06151940 A

**Littérature non-brevet citée dans la description**

- **LKISHAWA**. *Strain-induced enhancement of near-infrared absorption in Ge epitaxial layers grown on Si substrate*

- **XIE et al.** *Infrared absorption enhancement in light and heavyhole inverted Ga1xlnxAs/Al1ylnyAs quantum wells*